(19) **Europäisches Patentamt European Patent Office Office européen des brevets**

(11) **EP 4 694 656 A1**

(12) **EUROPEAN PATENT APPLICATION**
published in accordance with Art. 153(4) EPC

(43) Date of publication:
**11.02.2026 Bulletin 2026/07**

(21) Application number: 23930937.0

(22) Date of filing: **19.12.2023**

(51) International Patent Classification (IPC):
*H10N 30/853* (2023.01)     *H10N 30/01* (2023.01)
*H10N 30/30* (2023.01)     *H10N 30/076* (2023.01)
*H10N 30/079* (2023.01)     *H10N 30/87* (2023.01)
*H10N 30/093* (2023.01)

(52) Cooperative Patent Classification (CPC):
**H10N 30/8542; H10N 30/076; H10N 30/079;
H10N 30/708;** H10N 30/2042; H10N 30/2047

(86) International application number:
**PCT/JP2023/045473**

(87) International publication number:
**WO 2024/202318 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **29.03.2023 JP 2023052799**

(71) Applicant: **Sumitomo Chemical Company, Limited
Tokyo 103-6020 (JP)**

(72) Inventors:
• **KURODA, Toshiaki**
  **Hitachi-shi, Ibaraki 319-1418 (JP)**
• **SHIBATA, Kenji**
  **Hitachi-shi, Ibaraki 319-1418 (JP)**
• **WATANABE, Kazutoshi**
  **Hitachi-shi, Ibaraki 319-1418 (JP)**

(74) Representative: **Vossius & Partner
Patentanwälte Rechtsanwälte mbB
Siebertstrasse 3
81675 München (DE)**

(54) **PIEZOELECTRIC MULTILAYER BODY, METHOD FOR PRODUCING PIEZOELECTRIC MULTILAYER BODY, AND PIEZOELECTRIC ELEMENT**

(57)     This disclosure involves a substrate, a bottom electrode film deposited on the substrate, and a piezoelectric film deposited on the bottom electrode film, the piezoelectric film being constituted by an alkali niobium oxide containing potassium, sodium, niobium and oxygen, wherein: in a hysteresis curve representing a correlation between a polarization amount and an applied electric field, a median value of a coercive electric field between a coercive electric field $E_C^+$ on a positive electric field side and a coercive electric field $E_C^-$ on a negative electric field side is a positive value, the hysteresis curve being obtained by applying an electric field to the piezoelectric film under a predetermined condition; a relative dielectric constant of the piezoelectric film is 490 or less; and a film stress of the piezoelectric film is 150 MPa or less.

FIG. 1

EP 4 694 656 A1

**Description**

FIELD AND BACKGROUND OF THE INVENTION

The present disclosure relates to a piezoelectric stack, a method for manufacturing the piezoelectric stack, and a piezoelectric element.

Piezoelectric materials are widely used in functional electronic components such as sensors and actuators. A KNN-based ferroelectric containing potassium, sodium, niobium, and oxygen is used as the piezoelectric material, and a stack having a piezoelectric film (KNN film) deposited using such a piezoelectric material has been proposed. For example, Patent Document 1 discloses a KNN film which is a spontaneous polarization film capable of achieving sufficient piezoelectric displacement without polarization processing, in other words, a KNN film having, in a hysteresis curve representing a correlation between a polarization amount and an applied electric field, a median value of a coercive electric field between a coercive electric field $E_C^+$ on a positive electric field side and a coercive electric field $E_C^-$ on a negative electric field side of 10.8 kV/cm or more, the hysteresis curve being obtained by applying an electric field to the KNN film under a predetermined condition. In addition, Patent Document 1 discloses that the relative dielectric constant of the KNN film can be reduced by causing spontaneous polarization to be generated in the KNN film.

A piezoelectric film is required to have a low film stress (internal stress). For example, Patent Document 2 discloses that a bottom electrode film that serves as a base of a KNN film, is constituted by platinum (Pt), the grain size of the crystal grains constituting the bottom electrode film is controlled to be uniform so that the surface roughness of the bottom electrode film is reduced, and therefore, the stress at the interface with the KNN film is reduced and the film stress of the KNN film is reduced to 1.6 GPa or less. In addition, Patent Document 2 also discloses controlling (reducing) the film stress of the KNN film to 1.6 GPa or less by performing the heating processing after depositing the KNN film.

PRIOR ART DOCUMENTS

PATENT DOCUMENTS

Patent Document 1: Japanese Patent Laid Open Publication No. 2014-207429
Patent Document 2.: Japanese Patent Laid Open Publication No. 2011-029591

SUMMARY OF THE INVENTION

The KNN film obtained by the disclosure in Patent Document 1 is a spontaneous polarization film capable of achieving sufficient piezoelectric displacement without polarization processing, and has low relative dielectric constant, but the film stress is high. The KNN film obtained by the disclosure in Patent Document 2 has a low film stress, but the KNN film is not a spontaneous polarization film.

The present disclosure aims at providing a piezoelectric stack having a piezoelectric film, the piezoelectric film being a spontaneous polarization film, having a relative dielectric constant of 490 or less and a film stress of 150 MPa or less, and containing potassium, sodium, niobium and oxygen.

According to one aspect of the present disclosure, there are provided a piezoelectric stack and a piezoelectric element, each including:

a substrate;
a bottom electrode film deposited on the substrate; and
a piezoelectric film deposited on the bottom electrode film, the piezoelectric film being constituted by an alkali niobium oxide containing potassium, sodium, niobium and oxygen, wherein
in a hysteresis curve representing a correlation between a polarization amount and an applied electric field, a median value of a coercive electric field between a coercive electric field $E_C^+$ on a positive electric field side and a coercive electric field $E_C^-$ on a negative electric field side is a positive value, the hysteresis curve being obtained by applying an electric field to the piezoelectric film under a predetermined condition,
a relative dielectric constant of the piezoelectric film is 490 or less, and
a film stress of the piezoelectric film is 150 MPa or less.

According to another aspect of the present disclosure, there is provided a method for manufacturing a piezoelectric stack, the method including:

depositing a bottom electrode film on a substrate; and

depositing a piezoelectric film on the bottom electrode film, the piezoelectric film being constituted by an alkali niobium oxide containing potassium, sodium, niobium, and oxygen, wherein

the depositing of the piezoelectric film involves firstly depositing a first piezoelectric film as a part of the piezoelectric film at a first temperature at which a (001) orientation ratio becomes 95 % or more and a film stress becomes 100 MPa or less, and then depositing a second piezoelectric film as another part of the piezoelectric film on the first piezoelectric film at a second temperature at which the second piezoelectric film becomes a spontaneous polarization film.

According to the present disclosure, a piezoelectric stack having a piezoelectric film can be provided, the piezoelectric film being a spontaneous polarization film, having a relative dielectric constant of 490 or less and a film stress of 150 MPa or less, and containing potassium, sodium, niobium and oxygen.

BRIEF DESCRIPTION OF THE DRAWINGS

[FIG. 1] FIG. 1 is a view illustrating one example of cross-sectional structure of a piezoelectric stack according to one aspect of the present disclosure.

[FIG. 2] FIG. 2 is a view illustrating one example of structure of a simple piezoelectric element according to one aspect of the present disclosure.

[FIG. 3] FIG. 3 is a view illustrating one example of schematic structure of a piezoelectric element according to one aspect of the present disclosure.

[FIG. 4] FIG. 4 is a view illustrating one example of schematic structure of a piezoelectric device module according to one aspect of the present disclosure.

[FIG. 5] FIG. 5 is a polarization value-electric field hysteresis curve (P-E hysteresis curve) of Sample 3.

[FIG. 6] FIG. 6 is a P-E hysteresis curve of Sample 9.

[FIG. 7] FIG. 7(a) is a view illustrating one example of schematic structure of a simple unimorph cantilever fabricated using each sample and FIG. 7(b) is a view explaining a method for measuring a piezoelectric displacement amount.

[FIG. 8] FIG. 8(a) to FIG. 8(e) are graphs showing evaluation results on the necessity of polarization processing, the evaluation being conducted using a simple piezoelectric element fabricated from Sample 3.

[FIG. 9] FIG. 9(a) to FIG. 9(e) are graphs showing evaluation results on the necessity of polarization processing, the evaluation being conducted using a simple piezoelectric element fabricated from Sample 9.

[FIG. 10] FIG. 10(a) and FIG. 10(b) are graphs showing evaluation results on temperature withstand capability of spontaneous polarization, the evaluation being conducted using a simple piezoelectric element fabricated from Sample 1.

[FIG. 11] FIG. 11(a) and FIG. 11(b) are graphs showing evaluation results on temperature withstand capability of spontaneous polarization, the evaluation being conducted using a simple piezoelectric element fabricated from Sample 2.

DETAILED DESCRIPTION

<Findings Obtained by Inventors>

In Patent Document 1, when depositing a KNN film on a substrate such as silicon (Si) substrate by sputtering, a KNN film which is a spontaneous polarization film (hereinafter, also referred to as "spontaneous polarization KNN film") is obtained by depositing the KNN film at low temperature. The spontaneous polarization KNN film has an advantage in that no polarization processing is needed, the polarization processing being otherwise necessary to enable piezoelectric operation of a KNN film serving as a piezoelectric film. Stacks having spontaneous polarization KNN films are particularly advantageous when applied to sensor applications. However, the spontaneous polarization KNN film obtained in Patent Document 1 has high film stress. Note that, in a case where the temperature at the time of sputtering deposition is low, the film stress generated on a KNN film tends to become compressive stress, and in a case where the temperature at the time of sputtering deposition is high, the film stress generated on a KNN film tends to become tensile stress. When the KNN film has high film stress, for example, when the KNN film has film stress of more than 150 MPa, large structural deformation occurs in fabricating a piezoelectric element having membrane structure, cantilever structure, or the like. Consequently, the fabricated piezoelectric element does not correctly function. In addition, manufacturing yields of the piezoelectric elements and the piezoelectric device modules decrease. Therefore, the KNN film is required to have a low film stress, for example, the film stress of the KNN film is required to be 150 MPa or less.

The present inventors have intensively studied to obtain a KNN film having all of the following three features:

"being a spontaneous polarization film", "having a low relative dielectric constant", and "having a low film stress". Such a KNN film has never been obtained in the past. The present inventors have obtained the five findings listed below.

(The First Finding) A film stress of the KNN film obtained by sputtering deposition significantly depends on conditions in an early stage of deposition of the KNN film.

(The Second Finding) By firstly depositing a KNN film as a first layer (initial layer) (in an early stage of deposition) under a temperature condition at which a film stress becomes low, and then depositing a KNN film as a second layer on the first layer under a temperature condition at which the KNN film becomes a spontaneous polarization film, the film stress of the entire KNN film (stack of the first layer and second layer) can be significantly reduced even when the KNN film (second layer) is deposited at a temperature that is so low that a high film stress is usually generated.

(The Third Finding) In order to obtain a KNN film having a low relative dielectric constant with good reproducibility, a (001) orientation ratio of the KNN film needs to be high. In order to obtain a KNN film having a high (001) orientation ratio, the deposition temperature of the KNN film usually needs to be in a predetermined range. By depositing a KNN film as a first layer under a temperature condition at which a (001) orientation ratio becomes high in an early stage of deposition, and then depositing a KNN film as a second layer on the first layer under a temperature condition at which the KNN film becomes a spontaneous polarization film, a KNN film having a high (001) orientation ratio can be obtained even when the KNN film (second layer) is deposited at a temperature that is so low that the (001) orientation ratio usually decreases. Note that, the (001) orientation ratio of the KNN film refers to a orientation ratio of crystals constituting the KNN film toward a (001) direction, and will be described in detail later.

(The Fourth Finding) For example, in order to obtain a KNN film having a relative dielectric constant of 490 or less with good reproducibility, a (001) orientation ratio of the KNN film needs to be 90 % or more. By depositing a KNN film as a first layer under a condition at which a (001) orientation ratio becomes 95 % or more in an early stage of deposition, a KNN film having a (001) orientation ratio of 90 % or more can be obtained even when a KNN film as a second layer is deposited at a low temperature after depositing the first layer.

(The Fifth Finding) By depositing a KNN film as a first layer under a condition at which a film stress becomes low and a (001) orientation ratio becomes high in an early stage of deposition, and then depositing a KNN film as a second layer on the first layer under a temperature condition at which the KNN film becomes a spontaneous polarization film, a KNN film that is a spontaneous polarization film and has a low relative dielectric constant and low film stress, that is, a KNN film having all the three features above can be obtained.

Based on the five findings, the present inventors have found that by depositing a KNN film as a first layer under a temperature condition at which a film stress becomes 100 MPa or less and a (001) orientation ratio becomes 95 % or more in an early stage of deposition, and then depositing a KNN film as a second layer under a temperature condition at which the KNN film becomes a spontaneous polarization film, a KNN film that is a spontaneous polarization film and has a relative dielectric constant of 490 or less and a film stress of 150 MPa or less can be obtained.

The present disclosure has been made on the basis of the above-mentioned problems and findings obtained by the present inventors.

<Aspects of the Present Disclosure>

Hereinafter, one aspect of the present disclosure will be explained with reference to drawings.

(1) Configuration of Piezoelectric Stack

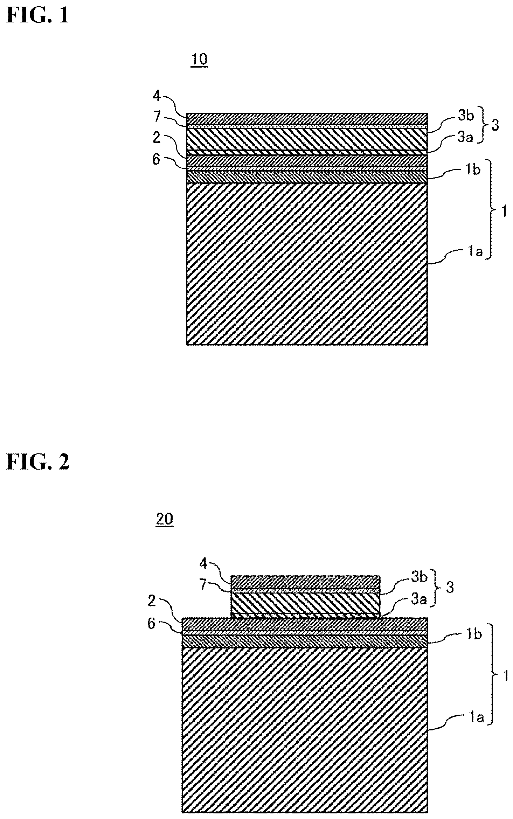

As illustrated in FIG. 1, a stack (stacked substrate) 10 having a piezoelectric film according to the present embodiment (hereinafter, also referred to as piezoelectric stack 10) includes a substrate 1, a bottom electrode film 2 deposited on the substrate 1, a piezoelectric film (piezoelectric thin film) 3 deposited on the bottom electrode film 2, and a top electrode film 4 deposited on the piezoelectric film 3.

As the substrate 1, a single crystal silicon (Si) substrate 1a on which a surface oxide film ($SiO_2$ film) 1b such as a thermal oxide film or a chemical vapor deposition (CVD) oxide film is formed, that is, a Si substrate having a surface oxide film may be suitably used. As the substrate 1, a Si substrate 1a having, instead of the surface oxide film 1b, an insulating film may be used, the insulating film being formed of an insulating material other than $SiO_2$. As the substrate 1, a Si substrate 1a in which a Si-(100), a Si-(111), or the like is exposed on the surface, that is, a Si substrate having no surface oxide film 1b or no insulating film may also be used. As the substrate 1, a silicon on insulator (SOI) substrate or a quartz glass ($SiO_2$) substrate may also be used. The thickness of the single crystal Si substrate 1a may be, for example, 300 $\mu$m or more and 1000 $\mu$m or less, and the thickness of the surface oxide film 1b may be, for example, 1 nm or more and 4000 nm or less.

The bottom electrode film 2 may be formed using, for example, platinum (Pt). The bottom electrode film 2 is a polycrystalline film. Hereinafter, a polycrystalline film deposited using Pt is also referred to as a Pt film. It is preferable that a (111) of the Pt film is parallel to the main surface of the substrate 1 (this includes the case where a (111) is inclined at an angle within $\pm 5°$ with respect to the main surface of the substrate 1), that is, the Pt film is preferably oriented in a (111) direction. The Pt film oriented in the (111) direction means that peaks other than peaks caused by the (111) are not observed in an X-ray diffraction pattern obtained by X-ray diffraction (XRD) measured on a surface of the piezoelectric film 3. As above, the main surface of the bottom electrode film 2 (the surface that serves as the base of the piezoelectric film 3) is preferably constituted by Pt-(111). The bottom electrode film 2 may be deposited by a method such as sputtering or evaporation. As the materials for the bottom electrode film 2, other than Pt, various metals such as gold (Au), ruthenium (Ru), and iridium (Ir), alloy containing these various metals as a main component, a metal oxide such as strontium ruthenium oxide ($SrRuO_3$, abbreviation: SRO) or lanthanum nickel oxide ($LaNiO_3$, abbreviation: LNO), and the like may be used. Note that, in a case of depositing the bottom electrode film 2 by using metal oxide, the crystals constituting the bottom electrode film 2 are preferably oriented preferentially in the (001) direction with respect to a surface of the substrate 1. The bottom electrode film 2 may be a single-layer film formed using the above-described various metals, an alloy containing the above-described various metals as a main component, a metal oxide, or the like. The bottom electrode film 2 may be a stack of a Pt film and a film containing SRO as a main component and provided on the Pt film, a stack of a Pt film and a film containing LNO as a main component and provided on the Pt film, or the like. The thickness of the bottom electrode film 2 (in a case where the bottom electrode film 2 is a stack, the total thickness of all layers) may be 100 nm or more and 400 nm or less, for example.

An adhesion layer 6 may be provided between the substrate 1 and the bottom electrode film 2 in order to enhance adhesion therebetween. The adhesion layer 6 may be a layer containing, for example, zinc (Zn) and oxygen (O) as main components (hereinafter, also referred to as a "ZnO layer"). The ZnO layer may be formed using, for example, zinc oxide. It is preferable that the composition ratio of Zn and O constituting the ZnO layer satisfies the relationship of Zn:O = 1:1 but the composition ratio is not limited thereto, and there may be some degree of variation. The ZnO layer is a polycrystalline layer. It is preferable that a (0001) of the ZnO layer is parallel to the main surface of the substrate 1 (this includes the case where the (0001) is inclined at an angle within $\pm 5°$ with respect to the main surface of the substrate 1), that is, the ZnO layer is preferably oriented in the (0001) direction. The ZnO layer being oriented in the (0001) direction means that, in an X-ray diffraction pattern obtained by XRD measured on a surface of the piezoelectric film 3, peak intensity caused by a (0002) is high. As above, the main surface of the ZnO layer (the surface that serves as the base of the bottom electrode film 2) is preferably constituted by ZnO-(0001). The ZnO layer may be deposited by a method such as sputtering or evaporation. The thickness of the ZnO layer may be, for example, 1 nm or more and 200 nm or less, preferably 10 nm or more and 50 nm or less. As the adhesion layer 6, a layer containing, for example, titanium (Ti), tantalum (Ta), titanium oxide ($TiO_2$), nickel (Ni), ruthenium oxide ($RuO_2$), iridium oxide ($IrO_2$), or the like as a main component may be provided. Such an adhesion layer 6 may also be deposited by a method such as sputtering or evaporation, and the thickness of the adhesion layer 6 may be, for example, 1 nm or more and 200 nm or less, preferably 10 nm or more and 50 nm or less. As used herein, the adhesion layer 6 provided between the substrate 1 and the bottom electrode film 2 may be referred to as a bottom adhesion layer 6.

The piezoelectric film 3 is formed of, for example, an alkali niobium oxide containing potassium (K), sodium (Na), niobium (Nb), and oxygen (O). That is, the piezoelectric film 3 contains as a main component an alkali niobium oxide containing K, Na, Nb, and O. The piezoelectric film 3 may be formed using an alkali niobium oxide represented by a composition formula $(K_{1-x}Na_x)NbO_3$, that is, potassium sodium niobate (KNN). The coefficient x [= Na/(K + Na)] in the above composition formula may be within a range of 0<x<1, preferably $0.4 \leq x \leq 0.8$. The piezoelectric film 3 is a polycrystalline film of KNN (hereinafter, also referred to as a KNN film 3). The crystal structure of KNN is a perovskite structure. In other words, the KNN film 3 has a perovskite structure. In addition, it is preferable that half or more crystals of the crystal groups constituting the KNN film 3 have columnar structure. As used herein, the crystal system of KNN is regarded as a tetragonal system. The KNN film 3 may be deposited by sputtering. The thickness of the KNN film 3 may be, for example, 0.5 $\mu$m or more and 5 $\mu$m or less, preferably 1 $\mu$m or more and 3 $\mu$m or less.

The crystals constituting the KNN film 3 are preferentially oriented in the (001) direction with respect to the main surface of the substrate 1 (when the substrate 1 is, for example, a Si substrate 1a having a surface oxide film 1b, an insulating film, or the like, then the Si substrate 1a). That is, the main surface of the KNN film 3 (the surface that serves as the base of the top electrode film 4) is mainly constituted by KNN-(001). For example, by directly depositing the KNN film 3 on the Pt film (bottom electrode film 2), the KNN film 3 having a main surface that is mainly constituted by KNN-(001) can be obtained, the main surface of the Pt film being mainly constituted by Pt-(111). As used herein, the crystals constituting the KNN film 3 being oriented in a (001) direction means that (001) of the crystals constituting the KNN film 3 is parallel or substantially parallel to the main surface of the substrate 1. In addition, the crystals constituting the KNN film 3 being preferentially oriented in a (001) direction means that there are many crystals whose (001) is parallel or substantially parallel to the main surface of the substrate 1.

The alkali niobium oxide constituting the KNN film 3 may further contain at least one element (dopant) selected from the group consisting of lithium (Li), magnesium (Mg), calcium (Ca), strontium (Sr), barium (Ba), bismuth (Bi), antimony (Sb), vanadium (V), indium (In), tantalum (Ta), molybdenum (Mo), tungsten (W), chromium (Cr), Ti, zirconium (Zr), hafnium (Hf), scandium (Sc), yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), lutetium (Lu), copper (Cu), zinc (Zn), silver (Ag), manganese (Mn), iron (Fe), cobalt (Co), Ni, aluminum (Al), Si, germanium (Ge), tin (Sn), and gallium (Ga). The concentration of the element in the alkali niobium oxide may be, for example, 5 atomic percent or less (in the case where more than one element mentioned above is contained, the total concentration of the elements may be 5 atomic percent or less).

As will be described in detail later, in the present embodiment, a first KNN film 3a (a first piezoelectric film, hereinafter, also referred to as "KNN film 3a") as a part of the KNN film 3 is firstly deposited at a first temperature at which a (001) orientation ratio becomes 95 % or more and a film stress becomes 100 MPa or less, and then a second KNN film 3b (a second piezoelectric film, hereinafter, also referred to as "KNN film 3b") as another part of the KNN film 3 is deposited on the KNN film 3a at a second temperature at which the KNN film 3b becomes a spontaneous polarization film. Accordingly, the KNN film 3 (that is, the stack of the KNN film 3a and the KNN film 3b) in the present embodiment has all of features 1 to 3 described later. In addition, the KNN film 3 in the present embodiment may further have feature 4 described later.

Hereinafter, features 1 to 4 that the KNN film 3 of the present embodiment may have will be explained.

(Feature 1)

The KNN film 3 has a feature in which "in a hysteresis curve (P-E hysteresis curve) representing a correlation between a polarization amount (P) of the KNN film 3 and an applied electric field (E), a median value of a coercive electric field between a coercive electric field $E_C^+$ on a positive electric field side and a coercive electric field $E_C^-$ on a negative electric field side is a positive value, the hysteresis curve being obtained by applying an electric field to the KNN film 3 under a predetermined condition."

The P-E hysteresis curve of the present embodiment is created by, for example, depositing the top electrode film 4 on the KNN film 3 having a thickness of 2 $\mu$m, applying an electric field of a triangular wave or a sinusoidal wave (sin wave) of -150 kV/cm to +150 kV/cm (that is, a voltage of a triangular wave or a sin wave of -30 V to +30 V) to the KNN film 3 through the top electrode film 4 at a frequency of 1 kHz in a state in which the bottom electrode film 2 is grounded, measuring the polarization amount of the KNN film 3 while applying this electric field, and plotting the obtained polarization amount. The "coercive electric field" is two electric field values when the polarization amount becomes 0 $\mu$C/cm$^2$, that is, an intersection at the x-axis in the P-E hysteresis curve. The "coercive electric field $E_C^+$" is an electric field value on the positive electric field side when the polarization amount becomes 0 $\mu$C/cm$^2$. The "coercive electric field $E_C^-$" is an electric field value on the negative electric field side when the polarization amount becomes 0 $\mu$C/cm$^2$. The "median value of the coercive electric field" is a value calculated by the formula $(E_C^+ - E_C^-)/2$.

As mentioned above, the KNN film 3 in the present embodiment has the feature in which, in the P-E hysteresis curve, the median value of the coercive electric field is a positive value. The KNN film 3 having this feature is a spontaneous polarization film (spontaneous polarization KNN film) in which polarization directions are aligned in a uniform direction (for example, upward).

The term "spontaneous polarization film" as used herein means a KNN film 3 in which polarization directions are spontaneously aligned in a uniform direction (without even a single application of an electric field (voltage) through the bottom electrode film 2 and the top electrode film 4 after deposition). The term "upward" as used herein means a direction from the bottom electrode film 2 side to the top electrode film 4 side. The phrase "the polarization directions are aligned in a uniform direction" means that a majority (more than half) of the crystals constituting the KNN film 3 are polarized in the uniform direction. For example, polarization directions being aligned upward means that polarization directions of the majority of the crystals constituting the KNN film 3 are upward.

Note that, in a KNN film which is not a spontaneous polarization film, a P-E hysteresis curve generally exhibits a graph having origin symmetry, and the absolute values of the coercive electric field $E_C^+$ and the coercive electric field $E_C^-$ have substantially the same value. When a piezoelectric element 20 to be described later, such as a sensor device, is fabricated using a piezoelectric stack having such a KNN film, polarization processing needs to be performed in the fabrication process. Note that, the "polarization processing" is for applying a large electric field (when necessary, under heating) to the KNN film 3 so as to align polarization directions of the KNN film 3 with a uniform direction (direction of the applied electric field).

Since the KNN film 3 is a spontaneous polarization film, no polarization processing is needed when the later-described piezoelectric element 20 is fabricated using the piezoelectric stack 10 having the KNN film 3 of the present embodiment.

The median value of the coercive electric field is preferably 10 kV/cm or more. Accordingly, more crystals among the crystals constituting the KNN film 3 can be polarized in a uniform direction (for example, upward). Consequently, the direction of the spontaneous polarization generated in the KNN film 3 (that is, the polarization direction of the KNN film 3) is stabilized, and thereby the KNN film 3 in which no polarization processing is needed can certainly be obtained.

The median value of the coercive electric field is preferably 100 kV/cm or less, more preferably 70 kV/cm or less. Having such a median value enables prevention of degradation in the piezoelectric property (for example, piezoelectric constant) of the KNN film 3.

The polarization property of the KNN film 3 is maintained (not lost) even when the KNN film 3 is exposed to a high temperature, for example, even when the KNN film 3 undergoes a thermal history of 400 °C or more. For example, spontaneous polarization generated in the KNN film 3 is maintained even when the KNN film 3 is exposed to a high temperature in performing processing such as depositing the top electrode film 4, annealing, forming the insulating film 8 and the metal wirings 9a and 9b in a manner described later (for example, processing of depositing the insulating film 8 by plasma CVD or ALD, and patterning), and implementing (for example, wire bonding, die bonding, and reflow soldering), after deposition of the KNN film 3. The inventors have confirmed that the polarization property of the KNN film 3 is maintained without degradation even when the KNN film 3 undergoes a thermal history of 500 °C. In addition, the inventors have confirmed that the polarization property of the KNN film 3 is degraded to some extent when the KNN film 3 undergoes a thermal history of about 600 °C, yet the spontaneous polarization generated in the KNN film 3 is still maintained. Accordingly, the later-described piezoelectric element 20 (piezoelectric device module 30) obtained by processing the piezoelectric stack 10 having the KNN film 3 can be suitably applied to sensor applications. In addition, degradation in performance of a sensor fabricated using the piezoelectric element 20 can be prevented.

(Feature 2)

The KNN film 3 further has a feature of "having a relative dielectric constant of 490 or less."

Since the KNN film 3 has the relative dielectric constant of 490 or less, a high-sensitivity sensor can be obtained when the later-described piezoelectric element 20 (piezoelectric device module 30) obtained by processing the piezoelectric stack 10 is applied to sensor applications. Note that, as the relative dielectric constant of the KNN film 3 is reduced, the sensitivity of a sensor fabricated by processing the piezoelectric stack 10 becomes higher.

In order to express this feature with good (certain) reproducibility, a (001) orientation ratio of the KNN film 3 needs to be 90 % or more. The (001) orientation ratio of the KNN film 3 refers to a orientation ratio of crystals constituting the KNN film 3 toward a (001) direction. The phrase "a (001) orientation ratio of the KNN film 3 is 90 % or more" means that, for example, 90 % or more crystals of crystal groups constituting the KNN film 3 is oriented to a (001) direction with respect to the main surface of the substrate 1. Note that, the term "orientation ratio" as used herein is a value calculated using the following formula (1) on the basis of a peak intensity of an X-ray diffraction pattern ($2\theta/\theta$) obtained by carrying out XRD measurement on the KNN film 3.

$$\text{Orientation ratio (\%)} = \{(001) \text{ peak intensity}/((001) \text{ peak intensity} + (110) \text{ peak intensity})\} \times 100 \qquad (1)$$

The term "(001) peak intensity" in formula (1) is an intensity of a diffraction peak caused by a crystal oriented in a (001) direction among crystals constituting the KNN film 3 (that is, the crystal having (001) being parallel to the main surface of the substrate 1) in an X-ray diffraction pattern obtained by carrying out XRD measurement on the KNN film 3, and is an intensity of a peak appearing within the 2θ range of 20° to 23°. In a case where a plurality of peaks appear within the 2θ range of 20° to 23°, the (001) peak intensity is regarded as an intensity of the highest peak. In addition, the term "(110) peak intensity" in formula (1) is an intensity of a diffraction peak caused by a crystal oriented in a (110) direction among crystals constituting the KNN film 3 (that is, the crystal having (110) being parallel to the main surface of the substrate 1) in an X-ray diffraction pattern obtained by carrying out XRD measurement on the KNN film 3, and is an intensity of a peak appearing within the 2θ range of 30° to 33°. In a case where a plurality of peaks appear within the 2θ range of 30° to 33°, the (110) peak intensity is regarded as an intensity of the highest peak.

(Feature 3)

The KNN film 3 further has a feature of "having a film stress of 150 MPa or less."

Since the KNN film 3 has the film stress of 150 MPa or less, occurrence of large structural deformation can be prevented when fabricating a piezoelectric element 20 having membrane structure, cantilever structure, or the like by processing a piezoelectric stack 10 in a manner described later. Accordingly, the later-described piezoelectric element 20 (later-described piezoelectric device module 30) obtained by processing the piezoelectric stack 10 can operate normally.

(Feature 4)

The KNN film 3 may further have a feature in which "when an (alternating) negative voltage is continuously applied to the top electrode film 4 in such a manner that a unipolar alternating electric field of 300 kV/cm is generated between the bottom electrode film 2 and the top electrode film 4 (that is, in the KNN film 3), the number of application cycles of the negative voltage until a piezoelectric displacement amount of the KNN film 3 decreases to 80 % or less of an initial piezoelectric displacement value is more than 10 million."

For example, in a case of using a piezoelectric stack 10 having a KNN film 3 with a thickness of 2 μm, when continuously applying an alternating voltage of a unipolar triangular wave or a unipolar sinusoidal wave (sin wave) with amplitude in the range of 0 V to -60 V to the top electrode film 4 (to the KNN film 3 through the top electrode film 4) at a frequency of 300 Hz in a state in which the bottom electrode film 2 is grounded, the alternating voltage being applied in such a manner that the directions of the electric field applied to the KNN film 3 is not reversed (such that the directions of the electric field are aligned in one direction), the number of application cycles of the alternating voltage until a piezoelectric displacement amount of the KNN film 3 decreases to 80 % or less of an initial piezoelectric displacement value is more than 10 million.

The term "unipolar electric field" as used herein means an electric field directed at one direction even when the magnitude of a voltage applied to the KNN film 3 through the top electrode film 4 periodically varies within a range of, for example, 0 V to -60 V. In addition, as used herein, the phrase "the number of application cycles of a negative voltage until a piezoelectric displacement amount of the KNN film 3 decreases to 80 % or less of an initial piezoelectric displacement value when the negative voltage is continuously applied to the top electrode film 4 in such a manner that a unipolar alternating electric field of 300 kV/cm is generated in the KNN film 3" is also referred to as "the number of application cycles."

The KNN film 3 is deformed by applying an alternating voltage to the KNN film 3 through the top electrode film 4. As the applied voltage increases, the deformation of the KNN film 3 becomes larger. The KNN film 3 according to the present embodiment may have a feature in which the piezoelectric displacement amount is less likely to decrease, in other words, the KNN film 3 has excellent AC stress withstand capability, even when the KNN film 3 undergoes large deformation repeatedly by continuously being applied with a large alternating voltage.

In the piezoelectric stack 10 obtained by the above-mentioned novel method, the KNN film 3a having a high (001) orientation ratio and a low film stress, for example, the KNN film 3a having a (001) orientation ratio of 95 % or more and a film stress of 100 MPa or less is interposed between the bottom electrode film 2 and the KNN film 3b. Accordingly, the KNN film 3 (stack of the KNN film 3a and the KNN film 3b) according to the present embodiment can further have excellent AC stress withstand capability as compared with a case where the KNN film 3a is not interposed. This is considered to be because the presence of the interposed KNN film 3a can significantly improve the adhesion between the bottom electrode film 2 and the KNN film 3. The present inventors have found the following novel finding for the first time as a result of intensive studies: by interposing the KNN film 3a in the manner described above, the number of application cycles can be increased to more than 10 million, in other words, the AC stress withstand capability of the KNN film 3 can be enhanced.

Since the KNN film 3 has excellent AC stress withstand capability, reliability of the later-described piezoelectric element 20 (piezoelectric device module 30) obtained by processing the piezoelectric stack 10 can be improved.

The present inventors have confirmed that, in a piezoelectric stack 10 provided with a KNN film 3a having a (001) orientation ratio of 95 % or more and a film stress of 100 MPa or less interposed between the bottom electrode film 2 and the KNN film 3b, when a negative voltage is continuously applied to the KNN film 3 through the top electrode film 4 in such a manner that a unipolar alternating electric field of 300 kV/cm is generated in the KNN film 3, a piezoelectric displacement amount of the KNN film 3 can be maintained to 80 % or more of an initial piezoelectric displacement value after the number of application cycles reaches more than 10 million, or even 50 million or more.

On the contrary, in a case where the KNN film 3a is not interposed, that is, where a KNN film 3 is not constituted by a stack of the KNN film 3a and the KNN film 3b, in response to the KNN film 3 continuously undergoing large deformation by continuously being applied with a large alternating voltage through the top electrode film 4, the KNN film 3 peels off from the bottom electrode film 2 little by little. Consequently, the piezoelectric displacement amount of the KNN film 3 is likely to decrease.

The present inventors have confirmed that, in a piezoelectric stack provided with no KNN film 3a interposed between the bottom electrode film 2 and the KNN film 3b, when a negative voltage is continuously applied to the KNN film through the top electrode film 4 in such a manner that a unipolar alternating electric field of 300 kV/cm is generated in the KNN film, a piezoelectric displacement amount of a KNN film decreases to less than 80 % of an initial displacement value before the number of application cycles reaches 10 million.

As mentioned above, the KNN film 3 according to the present embodiment can have all of the features 1 to 3, preferably all of the features 1 to 4. Since the KNN film 3 has all of the features 1 to 3, the later-described piezoelectric element 20 (piezoelectric device module 30) obtained by processing the piezoelectric stack 10 having the KNN film 3 can be suitably applied to sensor applications. In addition, since the KNN film 3 has all of the features 1 to 4, the later-described piezoelectric element 20 (piezoelectric device module 30) can be more suitably applied to sensor applications.

In the present embodiment, when depositing the KNN film 3, the KNN film 3a is firstly deposited at a first temperature at which a (001) orientation ratio becomes 95 % or more and a film stress becomes 100 MPa or less, and then the second KNN film 3b is deposited on the KNN film 3a at a second temperature at which the KNN film 3b becomes a spontaneous polarization film. Therefore, the KNN film 3 according to the present embodiment has stacked structure of the KNN film 3a as a first layer (initial layer) deposited at the first temperature and the KNN film 3b as a second layer deposited at the second temperature.

Spontaneous polarization is not generated in the KNN film 3a deposited at the first temperature. In other words, the KNN film 3a is not a spontaneous polarization film. Therefore, when the ratio of a thickness of the KNN film 3a to the total thickness of the KNN film 3 (the total thickness of the KNN film 3a and the KNN film 3b) is increased, the feature 1 is less likely expressed. That is, spontaneous polarization is less likely generated in the KNN film 3. Therefore, it is preferable that the thickness of the KNN film 3a is reduced to a minimum thickness necessary to reduce the film stress of the KNN film 3 and to make the film stress of the entire KNN film 3 to 150 MPa or less. Although the thickness of the KNN film 3a is not strictly limited, the thickness of the KNN film 3a is preferably 20 % or less of the total thickness of the KNN film 3, for example. Accordingly, the KNN film 3 having the feature 1, namely, the KNN film 3 being a spontaneous polarization film can certainly be obtained.

The top electrode film 4 contains as a main component, for example, various metals such as Pt, Au, Al, or Cu or alloy containing the various metals. The top electrode film 4 may be deposited by a method such as sputtering, evaporation, plating, metal pasting, or the like. The top electrode film 4 does not significantly affect the crystal structure of the KNN film 3 unlike the bottom electrode film 2. Thus, materials, crystal structure, and deposition method of the top electrode film 4 is not particularly limited. An adhesion layer 7 may be provided between the KNN film 3 and the top electrode film 4 in order to enhance the adhesion therebetween, the adhesion layer 7 containing, for example, $RuO_2$, $IrO_2$, Ti, Ta, $TiO_2$, or Ni as a main component. The thickness of the top electrode film 4 may be, for example, 50 nm or more and 5000 nm or less, preferably 50 nm or more and 300 nm or less. In a case where the adhesion layer 7 is provided, the thickness of the adhesion layer 7 may be, for example, 1 nm or more and 200 nm or less, preferably 5 nm or more and 50 nm or less. As used herein, the adhesion layer 7 provided between the KNN film 3 and the top electrode film 4 may be referred to as a top adhesion layer 7.

(2) Method for Manufacturing Piezoelectric Stack, Piezoelectric Element, and Piezoelectric Device Module

A method for manufacturing the piezoelectric stack 10, the piezoelectric element, and the piezoelectric device module will be explained below.

(Deposition of Bottom Adhesion Layer and Bottom Electrode Film)

Firstly, a substrate 1 is prepared and a bottom adhesion layer 6 (for example, ZnO layer) and a bottom electrode film 2 (for example, Pt film) are deposited in this order by, for example, sputtering, on one of main surfaces of the substrate 1. Note that, a substrate 1 on which the bottom adhesion layer 6 and the bottom electrode film 2 have been previously deposited on one of the main surfaces may be prepared instead.

As conditions in depositing the ZnO layer as the bottom adhesion layer 6, the following are exemplified. The deposition time of the bottom adhesion layer 6 is appropriately adjusted according to the target thickness of the bottom adhesion layer 6.

Target: ZnO sintered ceramics
Temperature (Substrate Temperature): 200 °C or more and 700 °C or less, preferably 300 °C or more and 700 °C or less, more preferably 500 °C or more and 700 °C or less
RF-Power Density: 2 $W/cm^2$ or more and 6 $W/cm^2$ or less, preferably 3 $W/cm^2$ or more and 5 $W/cm^2$ or less
Atmosphere: Atmosphere of mixed gas of argon (Ar) gas and oxygen ($O_2$) gas (hereinafter, also referred to as "Ar/$O_2$ mixed gas atmosphere")
Ratio of Partial Pressure of Ar Gas to $O_2$ Gas (Partial Pressure of Ar Gas/Partial Pressure of $O_2$ Gas): 5/1 to 30/1, preferably 7/1 to 20/1, and more preferably 10/1 to 15/1
Atmospheric Pressure: 0.1 Pa or more and 0.5 Pa or less, preferably 0.2 Pa or more and 0.4 Pa or less
Thickness: 1 nm or more and 200 nm or less, preferably 10 nm or more and 50 nm or less

As used herein, a numerical range such as "5/1 to 30/1" means that the lower limit value and the upper limit value are included in the range. The same applies to different numerical range.

As conditions in depositing a Ti layer or the like as the bottom adhesion layer 6, the following are exemplified.

Target: Ti plate or the like
Temperature (Substrate Temperature): 100 °C or more and 500 °C or less, preferably 200 °C or more and 400 °C or less
Atmosphere: Ar gas atmosphere

Atmospheric Pressure: 0.1 Pa or more and 0.5 Pa or less, preferably 0.2 Pa or more and 0.4 Pa or less

The other conditions may be similar to the conditions in providing the ZnO layer.

As conditions in depositing a Pt film as the bottom electrode film 2, the following are exemplified. The deposition time of the bottom electrode film 2 is appropriately adjusted according to the target thickness of the bottom electrode film 2.

Target: Pt plate
Temperature (Substrate Temperature): 200 °C or more and 600 °C or less, preferably 300 °C or more and 500 °C or less
RF-Power Density: 1 $W/cm^2$ or more and 5 $W/cm^2$ or less, preferably 2 $W/cm^2$ or more and 4 $W/cm^2$ or less
Atmosphere: Ar gas atmosphere
Atmospheric Pressure: 0.1 Pa or more and 0.5 Pa or less, preferably 0.2 Pa or more and 0.4 Pa or less
Thickness: 100 nm or more and 400 nm or less

(Deposition of KNN film)

After the deposition of the bottom adhesion layer 6 and the bottom electrode film 2, a KNN film 3 is then deposited on the bottom electrode film 2 by sputtering such as RF magnetron sputtering. The composition of the KNN film 3 can be adjusted by, for example, controlling composition of a target used at the time of sputtering deposition. The target can be fabricated by mixing $K_2CO_3$ powder, $Na_2CO_3$ powder, $Nb_2O_5$ powder, and the like and firing the mixture for example. The composition of the target can be controlled by adjusting mixing ratio of $K_2CO_3$ powder, $Na_2CO_3$ powder, $Nb_2O_5$ powder, and the like. In a case of depositing a KNN film 3 containing the above-mentioned elements such as Cu or Mn, a target fabricated by mixing Cu powder (or CuO powder), Mn powder (or MnO powder), or the like at a predetermined ratio in addition to the above-mentioned powders may be used.

The deposition of the KNN film 3 is performed in two stages while changing temperature conditions. Specifically, the KNN film 3a is firstly deposited (in the early stage of deposition) at a first temperature and then the KNN film 3b is deposited at a second temperature.

The first temperature is a temperature at which a (001) orientation ratio of the KNN film 3a becomes 95 % or more and a film stress becomes 100 MPa or less. For example, the first temperature is a temperature at which the

(001) orientation ratio of the KNN film 3a becomes 95 % or more when the KNN film 3a having a thickness of 2 $\mu$m ($\pm$10 %) is deposited at the first temperature. In addition, the first temperature is a temperature at which the film stress of the KNN film 3a becomes 100 MPa or less when the KNN film 3a having a thickness of 2 $\mu$m ($\pm$10 %) is deposited at the first temperature, for example.

The second temperature is a temperature at which the KNN film 3b becomes a spontaneous polarization film, that is, a temperature at which the median value of the coercive electric field in a P-E hysteresis curve becomes a positive value. For example, the second temperature is a temperature at which the KNN film 3b becomes a spontaneous polarization film when the KNN film 3b having a thickness of 2 $\mu$m ($\pm$10 %) is deposited at the second temperature.

While the first temperature and the second temperature may depend on a sputtering deposition apparatus and deposition conditions to some extent, in the sputtering deposition of the KNN film 3 in the present embodiment, the second temperature is usually lower than the first temperature (first temperature > second temperature). For example, the first temperature may be within a range of 550 °C or more and 600 °C or less, and the second temperature may be within a range of 400 °C or more and 500 °C or less.

As conditions in depositing the KNN film 3 (KNN film 3a and KNN film 3b) other than the temperature, the following conditions are exemplified for deposition at both of the first temperature and the second temperature.

RF-Power Density: 2.7 $W/cm^2$ or more and 4.1 $W/cm^2$ or less, preferably 2.8 $W/cm^2$ or more and 3.8 $W/cm^2$ or less
Atmosphere: atmosphere containing at least Ar gas, preferably $Ar/O_2$ mixed gas atmosphere
Atmospheric Pressure: 0.03 Pa or more and 0.5 Pa or less, preferably 0.04 Pa or more and 0.4 Pa or less
Ratio of Partial Pressure of $O_2$ Gas to Ar Gas (Partial Pressure of $O_2$ Gas/Partial Pressure of Ar Gas): 0 to 1/20, preferably 0 to 1/30
Deposition Rate: 0.5 $\mu$m/hr or more and 4 $\mu$m/hr or less, preferably 0.5 $\mu$m/hr or more and 2 $\mu$m/hr or less
Total Thickness of KNN Film: 0.5 $\mu$m or more and 5 $\mu$m or less, preferably 1 $\mu$m or more and 3 $\mu$m or less

Note that, the phrase "partial pressure of $O_2$ gas/partial pressure of Ar gas: 0 (zero)" means the case where the partial pressure of $O_2$ gas is 0, that is, the atmosphere consists only of Ar gas. The term "total thickness of the KNN film" refers to the total thickness of the KNN film 3a deposited at the first temperature and the KNN film 3b deposited at the second temperature. The deposition time of the KNN film 3a and the KNN film 3b is appropriately adjusted according to the target thickness of the KNN films 3a and 3b. As mentioned above, it is preferable that the thickness of the KNN film 3a is a minimum thickness necessary to reduce the film stress in the KNN film 3b in the deposition under the second temperature and to make the film stress of the entire KNN film 3 to 150 MPa or less. Therefore, the deposition time (deposition time under the first temperature) of the KNN film 3a is preferably adjusted in such a manner that the thickness of the KNN film 3a becomes 20 % or less of the total thickness of the KNN film 3, for example.

Firstly depositing the KNN film 3a at the first temperature at which the (001) orientation ratio becomes 95 % or more and the film stress becomes 100 MPa or less, and then depositing the KNN film 3b on the KNN film 3a at the second temperature at which the KNN film 3b becomes a spontaneous polarization film in the manner mentioned above ensures that a (001) orientation ratio of the entire KNN film 3 is 90 % or more after the deposition of the KNN film 3b and also ensures significant reduction in the film stress of the entire KNN film 3 after the deposition of the KNN film 3b, even when the second temperature is so low that the (001) orientation ratio decreases or a high film stress is generated on the KNN film 3b. Consequently, the KNN film 3 can be a spontaneous polarization film which has the relative dielectric constant of the entire KNN film 3 of 490 or less with good reproducibility and the film stress of the entire KNN film 3 of 150 MPa or less. In other words, the KNN film 3 having all of the features 1 to 3 can be obtained by depositing the KNN film 3 (KNN film 3a and KNN film 3b) in two stages while changing temperature under the above-mentioned conditions. Further, the KNN film 3 having all of the features 1 to 4 can also be obtained by depositing the KNN film 3 in two stages while changing temperature under the above-mentioned conditions, in other words, by providing the KNN film 3a having a high (001) orientation ratio and a low film stress.

(Deposition of Top Adhesion Layer and Top Electrode Film)

After the deposition of the KNN film 3, a top adhesion layer 7 (for example, $RuO_2$ layer) and a top electrode film 4 (for example, Pt film) are deposited on the KNN film 3 in this order by, for example, sputtering.

As conditions in depositing the $RuO_2$ layer or the like as the top adhesion layer 7, the following are exemplified. The deposition time of the top adhesion layer 7 is appropriately adjusted according to the target thickness of the top adhesion layer 7.

Target: Ru plate or the like
Temperature (Substrate Temperature): Room temperature (25 °C) or more and 500 °C or less
RF-Power Density: 0.3 $W/cm^2$ or more and 2 $W/cm^2$ or less, preferably 0.5 $W/cm^2$ or more and 1 $W/cm^2$ or less
Atmosphere: $Ar/O_2$ mixed gas atmosphere
Ratio of Partial Pressure of Ar Gas to $O_2$ Gas (Partial Pressure of Ar Gas/Partial Pressure of $O_2$ Gas): 3/5 to 1/1, preferably 3/4 to 1/1
Atmospheric Pressure: 0.1 Pa or more and 1.0 Pa or less, preferably 0.2 Pa or more and 0.7 Pa or less
Thickness: 1 nm or more and 200 nm or less, preferably 5 nm or more and 50 nm or less

As conditions in depositing a Pt film or the like as the top electrode film 4, the following are exemplified. The deposition time of the top electrode film 4 is appropriately adjusted according to the target thickness of the top electrode film 4.

Target: Pt plate or the like
Temperature (Substrate Temperature): Room temperature (25 °C) or more and 500 °C or less
RF-Power Density: 1 $W/cm^2$ or more and 5 $W/cm^2$ or less, preferably 2 $W/cm^2$ or more and 4 $W/cm^2$ or less
Atmosphere: Ar gas atmosphere
Atmospheric Pressure: 0.1 Pa or more and 0.5 Pa or less, preferably 0.2 Pa or more and 0.4 Pa or less
Thickness: 50 nm or more and 5000 nm or less, preferably 50 nm or more and 300 nm or less

By depositing the bottom adhesion layer 6, the bottom electrode film 2, the KNN film 3 (KNN films 3a and 3b), the top adhesion layer 7, and the top electrode film 4 in this order in the manner mentioned above, such a piezoelectric stack 10 as illustrated in FIG. 1 can be obtained.

(Fabrication of Piezoelectric Element)

After fabricating such a piezoelectric stack 10 as illustrated in FIG. 1, the piezoelectric stack 10 is processed into an element (also referred to as piezoelectric element 20) having the KNN film 3.

Specifically, firstly, the top electrode film 4 (including the top adhesion layer 7) and the KNN film 3 are individually patterned by dry etching using, for example, Ar gas or reactive gas. In the patterning, the top electrode film 4 (including the top adhesion layer 7) and the KNN film 3 are formed into predetermined shapes, and a part of the bottom electrode film 2 is exposed. In the patterning, a photoresist may be used as an etching mask. FIG. 2 illustrates the piezoelectric stack 10 after completion of the patterning, that is, a piezoelectric element 20. The piezoelectric element 20 illustrated in FIG. 2 is also referred to as a simple piezoelectric element.

After fabrication of such a simple piezoelectric element as illustrated in FIG. 2, the bottom electrode film 2 and the bottom adhesion layer 6 are individually patterned by dry etching using, for example, Ar gas or reactive gas, and the bottom electrode film 2 and the bottom adhesion layer 6 are formed into predetermined shapes. In this patterning, a photoresist may be used as an etching mask.

After the patterning of the bottom electrode film 2 and the bottom adhesion layer 6, the insulating film 8 and metal wirings 9a and 9b are provided. Specifically, firstly, a layer composed of an insulating material is provided from the top electrode film 4 to the substrate 1 so as to cover the side surface of the KNN film 3, and the insulating film 8 is provided by patterning the layer composed of the insulating material by dry etching using Ar gas or reactive gas such as $CF_4$ gas, or by wet etching. The insulating film 8 may be formed using an oxide such as silicon oxide ($SiO_2$), aluminum oxide ($Al_2O_3$), or tantalum oxide ($Ta_2O_5$), or the like. The insulating film 8 may be a single-layer film, or a stack in which a plurality of layers are stacked. The insulating film 8 may be provided by a method such as CVD or sputtering.

After provision of the insulating film 8, a layer composed of a material containing metal (metal wiring layer) is provided. Then, the metal wiring layer is patterned by dry etching using Ar gas or reactive gas, or by wet etching, thereby forming the metal wirings 9a and 9b. The metal wiring 9a is formed (patterned) so as to be connected to (in contact with) the bottom electrode film 2 and not connected to (not in contact with) the top electrode film 4, and the metal wiring 9b is formed so as to be connected to the top electrode film 4 and not connected to the bottom electrode film 2. The metal wirings 9a and 9b may each be formed using, for example, various metals such as Au, Al, Ti, or Cr, or alloy containing the various metals as a main component. The metal wirings 9a and 9b may be single-layer films, or stacks in which a plurality of layers are stacked. The metal wirings 9a and 9b (metal wiring layers) may be provided by a method such as sputtering, evaporation, plating, metal pasting, or the like.

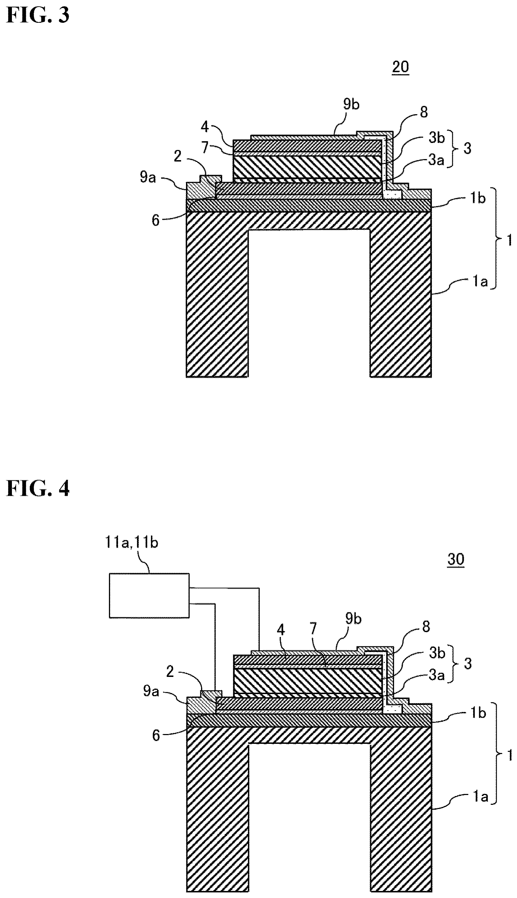

A part of the substrate 1 is removed from a back surface of the substrate 1 (between the two main surfaces of the substrate 1, the surface on the opposite side from the surface on which the bottom electrode film 2 and the like are deposited) by Deep-RIE or wet etching. Accordingly, the piezoelectric element 20 having membrane structure, cantilever structure, or the like, for example, such a membrane MEMS piezoelectric element 20 as illustrated in FIG. 3 can be obtained.

Etching conditions in patterning at the time of forming the insulating film 8 and the metal wirings 9a and 9b and etching conditions of the substrate 1 when processing the piezoelectric stack 10 into the piezoelectric element 20 may be general etching conditions used in a semiconductor device manufacturing process as long as the insulating properties of the KNN film 3 are not degraded.

(Fabrication of Piezoelectric Device Module)

By connecting a voltage detector 11a to the obtained piezoelectric element 20, a device module 30 (hereinafter, also referred to as a piezoelectric device module 30) having the KNN film 3 can be obtained. FIG. 4 is a view illustrating schematic structure of the piezoelectric device module 30 according to the present embodiment. The piezoelectric device module 30 at least includes the piezoelectric element 20 and the voltage detector 11a connected to the piezoelectric element 20. The voltage detector 11a is means that detects a voltage generated between the bottom electrode film 2 and the top electrode film 4 (between the electrodes). Various known means can be used as the voltage detector 11a.

Since the voltage detector 11a is connected between the bottom electrode film 2 and the top electrode film 4 of the piezoelectric element 20, the piezoelectric device module 30 can function as a sensor. When the KNN film 3 is deformed in accordance with a change in some physical quantity, a voltage is generated between the bottom electrode film 2 and the top electrode film 4 by the deformation. By detecting this voltage by means of the voltage detector 11a, the magnitude of the physical quantity applied to the KNN film 3 can be measured. In this case, examples of applications of the piezoelectric device module 30 include an angular velocity sensor, an ultrasonic sensor, a pressure sensor, and an acceleration sensor.

(3) Effects

According to the present embodiment, one or more of the following effects can be obtained.

(a) The KNN film 3 has all of the three features, namely, a feature in which a median value of a coercive electric field is a positive value in a P-E hysteresis curve (the feature 1), a feature in which a relative dielectric constant is 490 or less (the feature 2), and a feature in which a film stress is 150 MPa or less (the feature 3). That is, the KNN film 3 is a spontaneous polarization film having a low film stress and a low relative dielectric constant.

Since the KNN film 3 is a spontaneous polarization film, no polarization processing is needed in the KNN film 3 when the piezoelectric stack 10 is processed into a piezoelectric element 20 (piezoelectric device module 30). Because no polarization processing is needed, manufacturing process of the piezoelectric element 20 (piezoelectric device module 30) obtained by processing the piezoelectric stack 10 can be simplified.

Since the relative dielectric constant of the KNN film 3 is 490 or less, a high-sensitivity sensor can be obtained when the piezoelectric element 20 (piezoelectric device module 30) obtained by processing the piezoelectric stack 10 is applied to sensor applications.

Since the film stress of the KNN film 3 is 150 MPa or less, occurrence of large structural deformation can be prevented when fabricating the piezoelectric element 20 (piezoelectric device module 30) having membrane structure, cantilever structure, or the like by processing the piezoelectric stack 10. Accordingly, the piezoelectric element 20 (piezoelectric device module 30) obtained by processing the piezoelectric stack 10 can operate normally. For example, the piezoelectric element 20 (piezoelectric device module 30) can certainly be functioned as a sensor.

Since the KNN film 3 has all the features 1 to 3, the piezoelectric element 20 (piezoelectric device module 30) obtained by processing the piezoelectric stack 10 can be suitably applied to sensor applications.

(b) Since there is interposed the KNN film 3a having a high (001) orientation ratio and a low film stress between the bottom electrode film 2 and the KNN film 3b, the KNN film 3 may further have a feature in which the above-mentioned the number of application cycles is more than 10 million (the feature 4) in addition to the above-mentioned features 1 to 3. That is, the KNN film 3 may be a spontaneous polarization film which has a low film stress and a low relative dielectric constant as well as excellent AC stress withstand capability.

Since the KNN film 3 has excellent AC stress withstand capability, in other words, the piezoelectric displacement amount of the KNN film 3 is less likely to decrease even when the KNN film 3 undergoes large deformation repeatedly, reliability of the piezoelectric element 20 (piezoelectric device module 30) can be improved.

Since the KNN film 3 has all the features 1 to 4, the piezoelectric element 20 (piezoelectric device module 30) obtained by processing the piezoelectric stack 10 can be more suitably applied to sensor applications.

(c) The polarization property of the KNN film 3 according to the present embodiment is maintained even when the KNN film 3 is exposed to a high temperature. For example, the spontaneous polarization generated in the KNN film 3 is maintained even when the KNN film 3 is exposed to a high temperature in performing processing such as depositing the top electrode film 4, annealing, forming the insulating film 8 and the metal wirings 9a and 9b, and implementing, after deposition of the KNN film 3. Accordingly, the piezoelectric element 20 (piezoelectric device module 30) obtained by processing the piezoelectric stack 10 can be more suitably applied to sensor applications. In addition, degradation in performance of a sensor fabricated using the piezoelectric element 20 (piezoelectric device module 30) can be prevented.

(d) Since the median value of the coercive electric field is 10 kV/cm or more, the direction of the spontaneous polarization generated in the KNN film 3 can be stabilized, and thereby the KNN film 3 in which no polarization processing is needed can certainly be obtained. Further, since the median value of the coercive electric field is 10 kV/cm or more, an initial polarization direction (spontaneously polarized direction) can be maintained even when the KNN film 3 is erroneously applied with an electric field in the opposite direction (an electric field in a direction to reverse the polarization directions aligned in a uniform direction) during fabrication of the piezoelectric stack 10, piezoelectric element 20, and piezoelectric device module 30 or at the time of using the piezoelectric element 20 (piezoelectric device module 30).

(e) When depositing the KNN film 3, since the KNN film 3a is firstly deposited at the first temperature at which the (001) orientation ratio becomes 95 % or more and the film stress becomes 100 MPa or less, and then the KNN film 3b is deposited on the KNN film 3a at the second temperature at which the KNN film 3b becomes a spontaneous polarization film, the KNN film 3 having all of the features 1 to 3, preferably all of the features 1 to 4 can be obtained.

<Another Aspect>

The one aspect of the present disclosure has been explained as above. However, the present disclosure is not limited to the above-mentioned aspect, and various modifications can be made without departing from the scope of the present disclosure. Any of these aspects can be combined.

In the above-mentioned aspect, an example in which the piezoelectric device module 30 functions as a sensor has been explained, but the piezoelectric device module 30 is not limited thereto. That is, the piezoelectric device module 30 may function as an actuator instead. In this case, the piezoelectric device module 30 at least includes the piezoelectric element 20 and a voltage applicator 11b connected to the piezoelectric element 20 (see FIG. 4), the piezoelectric element 20 being obtained by forming the piezoelectric stack 10 into a predetermined shape. The voltage applicator 11b is means that applies a voltage between the bottom electrode film 2 and the top electrode film 4 (between the electrodes). Various known means can be used as the voltage applicator 11b. Since the voltage applicator 11b is connected between the bottom electrode film 2 and the top electrode film 4 of the piezoelectric element 20, the piezoelectric device module 30 can function as an actuator. By applying a voltage between the bottom electrode film 2 and the top electrode film 4 by means of the voltage applicator 11b, the KNN film 3 can be deformed. This deformation operation enables operation of the various structures connected to the piezoelectric device module 30. In this case, examples of applications of the piezoelectric device module 30 include a head for an inkjet printer, a MEMS mirror for an optical scanner, and a vibrator for an ultrasonic wave generating apparatus.

For example, when the above-mentioned piezoelectric stack 10 is formed into the piezoelectric element 20, the substrate 1 in the piezoelectric stack 10 may be replaced with another substrate as long as the piezoelectric device module 30 fabricated using the piezoelectric stack 10 (piezoelectric element 20) can be applied to a desired application such as a sensor.

EXAMPLES

Hereinafter, experimental results that support the effects of the above-described embodiments will be explained.

[Experiment 1]

Experiments were performed to confirm temperatures applicable as the first temperature and the second temperature when depositing the KNN film.

(Fabrication of Samples A to G)

As a substrate, a Si substrate having a surface oriented in a (100) direction, a thickness of 610 $\mu$m, a diameter of 6 inches (also referred to as "$\varphi$6 inches"), and a thermal oxide film (thickness: 200 nm) formed on the surface was prepared. Then, Samples A to G were fabricated as piezoelectric stacks by depositing a ZnO layer (thickness: 25 nm) as a bottom adhesion layer, a Pt film (preferentially oriented in a (111) direction with respect to the surface of the substrate, thickness: 200 nm) as a bottom electrode film, a KNN film (thickness: 2 $\mu$m) as a piezoelectric film, a RuO$_2$ layer (thickness: 10 nm) as a top adhesion layer, and a Pt film (thickness: 100 nm) as a top electrode film in this order on the thermal oxide film of the Si substrate. In each of Samples A to G, the bottom adhesion layer, the bottom electrode film, the KNN film, the top adhesion layer, and the top electrode film were all deposited by RF magnetron sputtering.

Conditions in depositing the ZnO layer as the bottom adhesion layer are as follows.

Target: ZnO sintered ceramics
Substrate Temperature: 500 °C
RF-Power Density: 4 W/cm$^2$
Atmosphere: Ar/O$_2$ mixed gas atmosphere
Atmospheric Pressure: 0.3 Pa
Partial Pressure of Ar Gas/Partial Pressure of O$_2$ Gas: 10/1
Deposition Time: 3 minutes (thickness: 25 nm)

Conditions in depositing the Pt film as the bottom electrode film are as follows.

Target: Pt plate
Substrate Temperature: 500 °C
RF-Power Density: 2 W/cm$^2$
Atmosphere: Ar gas atmosphere
Atmospheric Pressure: 0.3 Pa
Deposition Time: 14 minutes (thickness: 200 nm)

Conditions in depositing the KNN film are as follows.

Target: KNN sintered ceramics
RF-Power Density: 3 W/cm$^2$
Atmosphere: Ar/O$_2$ mixed gas atmosphere
Atmospheric Pressure: 0.1 Pa
Partial Pressure of O$_2$ Gas/Partial Pressure of Ar Gas: 1/20
Deposition Temperature: A predetermined temperature within a range of 300 °C or more and 650 °C or less
Deposition Time: 60 minutes (thickness: 2000 nm (2 $\mu$m))

Conditions in depositing the RuO$_2$ layer as the top adhesion layer are as follows.

Target: Ru plate
Substrate Temperature: Room temperature (25 °C)

RF-Power Density: 0.5 W/cm$^2$
Atmosphere: Ar/O$_2$ mixed gas atmosphere
Atmospheric Pressure: 0.3 Pa
Partial Pressure of Ar Gas/Partial Pressure of O$_2$ Gas: 1/1
Deposition Time: 6 minutes (thickness: 10 nm)

Conditions in depositing the Pt film as the top electrode film are as follows.

Target: Pt plate
Substrate Temperature: Room temperature (25 °C)
RF-Power Density: 2 W/cm$^2$
Atmosphere: Ar gas atmosphere
Atmospheric Pressure: 0.3 Pa
Deposition Time: 7 minutes (thickness: 100 nm)

Samples A to G were fabricated under conditions the same as the conditions described above except for the deposition temperature of the KNN film. The deposition temperature of the KNN film for Samples A to G are shown in Table 1 below.

<Evaluations>

For each of Samples A to G, a (001) orientation ratio of the KNN film, film stress of the KNN film, and a median value of the coercive electric field were evaluated.

(Evaluations on (001) Orientation Ratios)

The (001) orientation ratio of the KNN film was evaluated by calculating the (001) orientation ratio using the above formula (1) on the basis of peak intensity of an X-ray diffraction pattern (2θ/θ) obtained by carrying out XRD measurement on the KNN film. The XRD measurement was carried out after the deposition of the KNN film and before the deposition of the top adhesion layer and the top electrode film. Calculation results for (001) orientation ratios are shown in Table 1 below. Note that, the term "Orientation ratio" in Table 1 means a (001) orientation ratio of the KNN film.

(Evaluations on Film Stress)

Stress of a thin film on the substrate can be calculated by measuring the amount of warpage of the substrate caused due to the thin film, specifically, a radius of curvature of the warpage of the substrate, as in the following formula (2). Therefore, in the present evaluation, firstly, the radius of curvature R of the warpage of the substrate (Si substrate) of each sample was measured after depositing the bottom adhesion layer, bottom electrode film, and KNN film and before depositing the top adhesion layer and top electrode film. Then, film stress of the KNN film of each sample was calculated using the following formula (2). In the present evaluation, the radius of curvature R of the Si substrate was calculated from a warped shape of the Si substrate after the bottom adhesion layer, the bottom electrode film, and the KNN film were deposited, the warped shape being measured by a laser displacement meter.

$$\sigma = \left( \frac{E_s}{1 - \nu_s} \right) \frac{h^2}{6\,R\,t} \quad \cdot \cdot \cdot (2)$$

In formula (2), σ is stress of a thin film (KNN film), $E_s/(1-v_s)$ is a biaxial elastic modulus (Pa) of a substrate, h is a thickness (m) of the substrate, R is a radius of curvature (m) of warpage of the substrate, and t is a thickness (m) of the KNN film. In Samples A to G, since the Si substrate was used as the substrate, the value of the biaxial elastic modulus was set to 30.3. Also, film stress (σ) of the KNN film was calculated on the assumption that the Si substrate was sufficiently flat. While the bottom adhesion layer (ZnO layer) and the bottom electrode film (Pt film) are deposited in each of Samples A to G, the thickness of the bottom adhesion layer (25 nm) and the thickness of the bottom electrode film (200 nm) are sufficiently thinner as compared with the thickness of the KNN film (2 μm). Therefore, the influence of the bottom adhesion layer and the bottom electrode film was ignored in the calculation of the film stress of the KNN film.

Calculation results of the film stress of the KNN films of Samples A to G are shown in Table 1 below. In Table 1, the term "C" means that the film stress is compressive stress and the term "T" means that the film stress is tensile stress.

(Evaluations on Median Values of Coercive Electric Fields)

Evaluations on the median values of the coercive electric fields were performed in the manner described below. Firstly, after the fabrication of the piezoelectric stacks of Samples A to G, the top electrode film (including the top adhesion layer) and the KNN film were individually patterned by dry etching using Ar gas. In the patterning, such a simple piezoelectric element as illustrated in FIG. 2 was fabricated by using a photoresist as an etching mask, forming the top electrode film into a size of φ0.5 mm, and exposing a part of the bottom electrode film. The simple piezoelectric elements fabricated from Samples A to G were then used to create P-E hysteresis curves. Specifically, the P-E hysteresis curve was created by applying an electric field of a triangular wave or a sin wave of -150 kV/cm to +150 kV/cm to the KNN film through the top electrode film at a frequency of 1 kHz in a state in which the bottom electrode film was grounded, measuring the polarization amount of the KNN film, and plotting the obtained polarization amount and the applied electric field. An apparatus (DBLI) manufactured by aixACCT Systems was used to create the P-E hysteresis curve. Values of the coercive electric field $E_C^+$ and coercive electric field $E_C^-$ were obtained from each P-E hysteresis curve, and the median value of the coercive electric field (= $(E_C^+ - E_C^-)/2$) was calculated from the values of the coercive electric field $E_C^+$ and coercive electric field $E_C^-$. Calculation results of the median values of the coercive electric fields of Samples A to G are shown in Table 1 below. Note that, the term "Median value" in Table 1 means the median value of the coercive electric field.

[Table 1]

| Sample | Deposition temperature (°C) | Orientation ratio (%) | Film stress (MPa) | Median value (kV/cm) | Assessment |
|---|---|---|---|---|---|
| A | 300 | Un-measurable | 200 (C) | Un-measurable | (*1) |
| B | 400 | 90 | 250 (C) | +50 | (*2) |
| C | 450 | 95 | 200 (C) | +25 | (*2) |
| D | 500 | 100 | 150 (C) | +10 | (*2) |
| E | 550 | 100 | 50 (C) | 0 | (*3) |
| F | 600 | 95 | 100 (T) | 0 | (*3) |
| G | 650 | 90 | 200 (T) | 0 | (*4) |
| (*1) Crystal structure is not perovskite structure<br>(*2) Applicable as second temperature<br>(*3) Applicable as first temperature<br>(*4) Not applicable as first temperature or second temperature | | | | | |

In Sample A, crystal structure of the KNN film did not become a perovskite structure. Therefore, in an X-ray diffraction pattern obtained by carrying out XRD measurement, no peak was observed at least within the 2θ range of 20° to 23°. Consequently, a (001) orientation ratio could not be calculated. In addition, since crystal structure of the KNN film was not perovskite structure, the KNN film had a low breakdown voltage characteristic. Thus, an electric field of a triangular wave or a sin wave of -150 kV/cm to +150 kV/cm could not be applied to the KNN film through the top electrode film at a frequency of 1 kHz in creating a P-E hysteresis curve. As a result, a P-E hysteresis curve could not be created, and consequently, the median value of the coercive electric field could not be measured. Accordingly, the deposition temperature of Sample A is confirmed as not being applicable as either the first temperature or the second temperature.

In each of Samples B to D, the film stress is more than 100 MPa. Accordingly, the deposition temperatures of Samples B to D are confirmed as not being applicable as the first temperature. On the other hand, in Samples B to D, the median values of the coercive electric fields are 10 kV/cm or more. Accordingly, the deposition temperatures of Samples B to D, that is, a temperature range of 400 °C or more and 500 °C or less are temperatures at which the KNN films become spontaneous polarization films, and confirmed as being applicable as the second temperature.

In each of Samples E and F, the (001) orientation ratio is 95 % or more and the film stress is 100 MPa or less. Accordingly, the deposition temperatures of Samples E and F, that is, a temperature range of 550 °C or more and 600 °C or less, are confirmed as being applicable as the first temperature. On the other hand, in each of Samples E and F, the median value of the coercive electric field is 0 kV/cm. In other words, the KNN films of Samples E and F are not spontaneous polarization films. Accordingly, the deposition temperatures of the Samples E and F are confirmed as not being applicable as the second temperature.

In Sample G, the (001) orientation ratio is less than 95 % and the film stress is more than 100 MPa. In addition, in Sample G, the median value of the coercive electric field is 0 kV/cm. Accordingly, the deposition temperature of Sample G is confirmed as not being applicable as either the first temperature or the second temperature.

[Experiment 2]

Experiments were conducted to confirm the effects of depositing the KNN film in two stages while changing temperature.

(Fabrication of Samples 1 to 16)

As a substrate, a Si substrate having a surface oriented in a (100) direction, a thickness of 610 $\mu$m, a diameter of $\varphi$6 inches, and a thermal oxide film (thickness: 200 nm) formed on the surface was prepared. Then, Samples 1 to 16 were fabricated as piezoelectric stacks by depositing a ZnO layer (thickness: 25 nm) as a bottom adhesion layer, a Pt film (preferentially oriented in a (111) direction with respect to the surface of the substrate, thickness: 200 nm) as a bottom electrode film, a KNN film (thickness: 2 $\mu$m) as a piezoelectric film, a RuO$_2$ layer (thickness: 10 nm) as a top adhesion layer, and a Pt film (thickness: 100 nm) as a top electrode film in this order on the thermal oxide film of the Si substrate. The bottom adhesion layer, the bottom electrode film, the KNN film, the top adhesion layer, and the top electrode film were all deposited by RF magnetron sputtering.

In each of Samples 1 to 14, the KNN film was deposited in two stages while changing temperature conditions. Specifically, a first KNN film is firstly deposited at a first temperature and then a second KNN film is deposited on the first KNN film at a second temperature different from the first temperature. The first temperature and the second temperature for depositing the KNN films of Samples 1 to 14 are shown in Table 2 below. The deposition time under the first temperature was set to 6 minutes (thickness: 200 nm) and under the second temperature was set to 54 minutes (thickness: 1800 nm). In each of Samples 15 and 16, the KNN film was deposited at a predetermined temperature without changing the temperature conditions. The temperatures for depositing the KNN films of Samples 15 and 16 are shown in the column of "Second Temperature" in Table 2 below. The deposition time was set to 60 minutes (thickness: 2000 nm). Conditions in depositing the KNN film other than the deposition temperature and the deposition time, and conditions in depositing each film (each layer) other than the KNN film were the same as those in Experiment 1. Samples 1 to 16 were fabricated under conditions the same as the conditions described above, except for the deposition temperature (the first temperature and second temperature) of the KNN films.

<Evaluations>

For each of Samples 1 to 16, a median value of a coercive electric field, a relative dielectric constant of the KNN film, film stress of the KNN film, and AC stress withstand capability were evaluated. Using simple piezoelectric elements fabricated from Sample 3 and 9, evaluations were also conducted on the necessity of polarization processing. Using simple piezoelectric elements fabricated from Samples 1, 2, and 8, evaluations were also conducted on temperature withstand capability of spontaneous polarization generated in the KNN films. Using simple piezoelectric elements fabricated from Samples 3 and 9, evaluations were also conducted on heat resistance performance of piezoelectric elements.

(Evaluations on Median Values of Coercive Electric Fields)

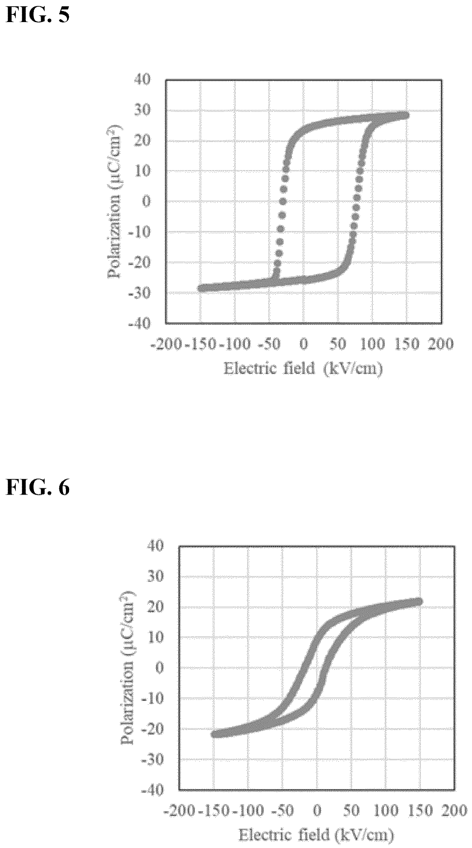

Using Samples 1 to 16, such simple piezoelectric elements as illustrated in FIG. 2 were fabricated by a method similar to the method described in the evaluations on the median values of the coercive electric fields in Experiment 1. The simple piezoelectric elements fabricated from Samples 1 to 16 were then used to create P-E hysteresis curves. The P-E hysteresis curves were created using conditions, method, and apparatus similar to those described in the evaluations on the median values of the coercive electric fields in Experiment 1. FIG. 5 shows the P-E hysteresis curve of Sample 3, and FIG. 6 shows the P-E hysteresis curve of Sample 9. Values of the coercive electric field $E_C{}^+$ and coercive electric field $E_C{}^-$ were obtained from each P-E hysteresis curve to calculate median values of the coercive electric fields. The calculation results of the median values of the coercive electric fields of Sample 1 to 16 are shown in Table 2 below. Note that, the term "Median Value" in Table 2 means the median value of the coercive electric field.

(Evaluations on Relative Dielectric Constants)

Using Samples 1 to 16, such simple piezoelectric elements as illustrated in FIG. 2 were fabricated by a method similar to the method described in the evaluations on the median values of the coercive electric fields in Experiment 1. The simple piezoelectric element fabricated from each of Samples 1 to 16 was then used to measure electrostatic capacitance under conditions of $\pm 1$ V and 1 kHz by connecting the bottom electrode film and the top electrode film to an LCR meter. The relative dielectric constant of the KNN film of each sample was calculated using each value of the measured electrostatic capacitance, the area (0.625 mm$^2$) of the top electrode film, and the thickness (2 $\mu$m) of the KNN film. The relative dielectric constants of Samples 1 to 16 are shown in Table 2 below.

(Evaluations on Film Stress)

For each of Samples 1 to 16, film stress of the KNN films were evaluated using similar method as the method described in the evaluations on film stress in Experiment 1. While the bottom adhesion layer and the bottom electrode film are deposited in each of Samples 1 to 16, the thickness of the bottom adhesion layer and the thickness of the bottom electrode film are sufficiently thinner as compared with the thickness of the KNN film similar to Samples A to G. Therefore, the influence of the bottom adhesion layer and the bottom electrode film was ignored in the calculation of the film stress of the KNN film. Calculation results of the film stress of the KNN films of Samples 1 to 16 are shown in Table 2 below. The terms "C" and "T" in Table 2 have similar meanings to the terms "C" and "T" in Table 1.

(Evaluations on AC stress withstand capability)

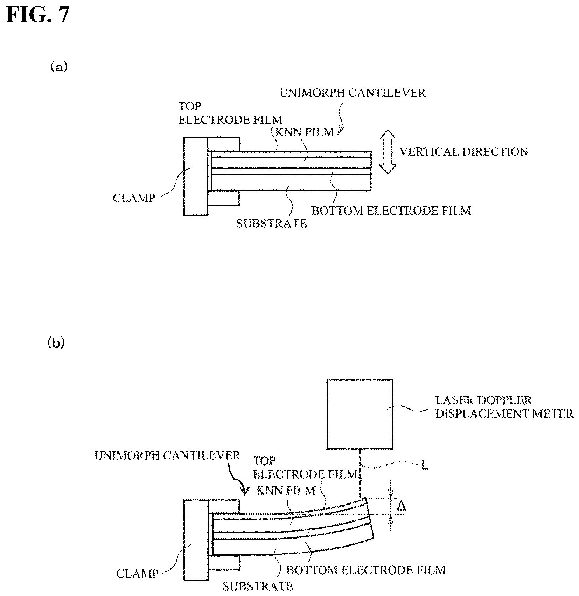

AC stress withstand capability was evaluated by measuring the AC stress lifetime. The AC stress lifetime was evaluated in the manner described below. Firstly, strip-shaped pieces each having a length of 20 mm and a width of 2.5 mm were cut out from each of Samples 1 to 16. Next, as illustrated in FIG. 7(a), a simple unimorph cantilever was fabricated by fixing one end in a longitudinal direction of the piece obtained from each of Samples 1 to 16 by a clamp, and connecting a voltage applicator (not illustrated) between the bottom electrode film and the top electrode film. Then, by using the voltage applicator, the KNN film (thickness: 2 $\mu$m) of the piece was continuously deformed by continuously applying a negative voltage to the KNN film through the top electrode film in such a manner that a unipolar alternating electric field of 300 kV/cm was generated between the bottom electrode film and the top electrode film (that is, in the KNN film), specifically, by continuously applying an alternating voltage of a unipolar sin wave with amplitude in the range of 0 V to -60 V to the KNN film through the top electrode film at a frequency of 300 Hz in a state in which the bottom electrode film was grounded. The deformation operation of the KNN film causes the entire cantilever to bend and stretch (vibrate) and a tip of the cantilever to continuously reciprocate in a vertical direction. A displacement amount $\Delta$ (piezoelectric displacement amount) of the tip of the cantilever at this time was measured by irradiating the tip of the cantilever with a laser beam L from a laser Doppler displacement meter as illustrated in FIG. 7(b). In the present evaluation, the measurement of the displacement amount $\Delta$ was carried out every time the number of application cycles reached 1 million. The number of application cycles at the time of when the displacement amount $\Delta$ became 80 % or less of the initial displacement value was defined as the AC stress lifetime. Note that, in a case where the displacement amount $\Delta$ was 80 % or more of the initial displacement value even after the number of application cycles reached 50 million, the measurement was stopped, and the measurement result of the AC stress lifetime was determined as more than 50 million times (>50 million times). The measurement results are shown in Table 2 below.

In FIGS. 7(a) and 7(b), for the sake of clarity, illustration of the bottom adhesion layer and the top adhesion layer is omitted, and a stack of the first KNN film and the second KNN film is illustrated as a KNN film.

[Table 2]

| Sample | Temperature | | Orientation ratio (%) | Median value (kV/cm) | Relative dielectric constant | Film stress (MPa) | AC stress lifetime |
|---|---|---|---|---|---|---|---|
| | First (°C) | Second (°C) | | | | | |
| 1 | 550 | 400 | 90 | +70 | 330 | 150 (C) | (*2) |
| 2 | 550 | 450 | 93 | +50 | 350 | 100 (C) | (*2) |
| 3 | 550 | 500 | 100 | +25 | 400 | 50 (C) | (*2) |
| 4 | 600 | 400 | 90 | +60 | 340 | 100 (C) | (*2) |
| 5 | 600 | 450 | 95 | +40 | 400 | 50 (C) | (*2) |
| 6 | 600 | 500 | 95 | +10 | 490 | 30 (C) | (*2) |
| 7 | 550 | 300 | (* 1) | (* 1) | 600 | 200 (C) | (* 1) |
| 8 | 550 | 600 | 100 | 0 | 490 | 50 (T) | (*2) |

(continued)

| Sample | Temperature | | Orientation ratio (%) | Median value (kV/cm) | Relative dielectric constant | Film stress (MPa) | AC stress lifetime |
|---|---|---|---|---|---|---|---|
| | First (°C) | Second (°C) | | | | | |
| 9 | 550 | 650 | 95 | 0 | 900 | 50 (C) | (*2) |
| 10 | 600 | 650 | 95 | 0 | 1000 | 150 (T) | (*2) |
| 11 | 650 | 400 | 85 | +60 | 510 | 200 (C) | (*3) |
| 12 | 650 | 500 | 88 | +10 | 520 | 160 (C) | (* 4) |
| 13 | 500 | 400 | 88 | +60 | 330 | 250 (C) | (*5) |
| 14 | 500 | 450 | 91 | +40 | 350 | 200 (C) | (*3) |
| 15 | - | 500 | 100 | +30 | 400 | 200 (C) | (*3) |
| 16 | - | 650 | 90 | 0 | 900 | 200 (T) | (*3) |

(*1) Un-measurable, (*2) >50 million times, (*3) 10 million times,
(*4) 7 million times, (*5) 8 million times

In each of Samples 1 to 6, the median value of the coercive electric field is a positive value, the relative dielectric constant is 490 or less, and the film stress is 150MPa or less. That is, it is found from Samples 1 to 6 that a KNN film having all three features described below can be obtained when depositing a KNN film, by firstly depositing the first KNN film at the first temperature at which the (001) orientation ratio becomes 95 % or more and the film stress becomes 100 MPa or less, and then depositing the second KNN film on the first KNN film at the second temperature at which the second KNN film becomes a spontaneous polarization film. The three features are: a feature in which a median value of a coercive electric field is a positive value (the feature 1); a feature in which a relative dielectric constant is 490 or less (the feature 2); and a feature in which a film stress is 150 MPa or less (the feature 3).

In Sample 7 in which the second temperature was set to 300 °C, the (001) orientation ratio could not be calculated and the median value of the coercive electric field could not be measured. This is considered to be because crystal structure of the second KNN film did not become a perovskite structure. In each of Samples 8 to 10, the median value of the coercive electric field is 0. This is considered to be because the second temperature is more than 500 °C (600 °C and 650 °C) in Samples 8 to 10. Accordingly, it can be confirmed that when the second temperature is not a temperature at which the second KNN film becomes a spontaneous polarization film, a KNN film that is a spontaneous polarization film, in other words, a KNN film having the feature 1 cannot be obtained. In each of Samples 11 and 12, the relative dielectric constant is more than 490 and the film stress is more than 150 MPa. This is considered to be because the first temperature is more than 600 °C (650 °C) in Samples 11 and 12. In addition, in each of Samples 13 and 14, the film stress is more than 150 MPa. This is considered to be because the first temperature is less than 550 °C (500 °C) in Samples 13 and 14. From Samples 11 to 14, it can be confirmed that when the first temperature is not a temperature at which the (001) orientation ratio of the first KNN film becomes 95 % or more and the film stress becomes 100 MPa or less, a KNN film having a relative dielectric constant of 490 or less and film stress of 150 MPa or less, that is, a KNN film having the features 2 and 3 cannot be obtained.

In addition, in each of Samples 1 to 6 and 8 to 10, the number of application cycles until a displacement amount Δ decreases to 80 % or less of an initial displacement value is more than 50 million. Therefore, Samples 1 to 6 and 8 to 10 have excellent AC stress withstand capability. This is considered to be because the first KNN film having a high (001) orientation ratio and a low film stress (for example, a first KNN film having a (001) orientation ratio of 95 % or more and a film stress of 100 MPa or less) is interposed between the bottom electrode film and the second KNN film.

Particularly, in each of Samples 1 to 6, the median value of the coercive electric field is a positive value, the relative dielectric constant is 490 or less, the film stress is 150MPa or less, and the number of application cycles is more than 10 million (50 million or more). Accordingly, it can be confirmed that each of Samples 1 to 6 further has a feature of having excellent AC stress withstand capability (the feature 4) in addition to the features 1 to 3. It can be confirmed from Samples 1 to 6 that a KNN film having all of the features 1 to 4 can be obtained when depositing the KNN films, by firstly depositing the first KNN film at the first temperature at which the (001) orientation ratio becomes 95 % or more and the film stress becomes 100 MPa or less, and then depositing the second KNN film on the first KNN film at the second temperature that is a predetermined temperature higher than the first temperature.

On the contrary, in Sample 7, a large voltage such as that generates a unipolar alternating electric field of 300 kV/cm in a KNN film could not be applied, and the number of application cycles could not be measured. This is considered to be because crystal structure of the second KNN film does not become a perovskite structure, and the KNN film has a low breakdown voltage characteristic. In addition, in each of Samples 11 to 16, the number of application cycles until a

displacement amount △ decreases to 80 % or less of an initial displacement value is 10 million or less. Therefore, Samples 11 to 16 have low AC stress withstand capability. This is considered to be because the first KNN film is not deposited at a temperature at which a (001) orientation ratio becomes 95 % or more and a film stress becomes 100 MPa or less in each of Samples 11 to 14, in other words, the first KNN film has a low (001) orientation ratio and high film stress. Further, this is considered to be because the KNN film is not constituted by a stack of the first KNN film and the second KNN film in each of Samples 15 and 16, specifically, because no KNN film having a high (001) orientation ratio and a low film stress (for example, a KNN film having a (001) orientation ratio of 95 % or more and a film stress of 100 MPa or less) is interposed between the bottom electrode film and the KNN film.

Note that, when depositing the KNN film in each of Samples 1 to 14, the deposition time under the first temperature was set to 6 minutes, but the deposition time is not limited thereto. The inventors have confirmed that, results similar to the above-mentioned results can be obtained as long as the deposition time under the first temperature is in a range of 1 minute or more and 12 minutes or less. It has been confirmed that, in the deposition of the KNN film, the deposition time under the first temperature, that is, an optimum thickness value of the KNN film deposited under the first temperature may include a certain allowable range.

(Evaluations on film stress)

In Experiments 1 and 2, the film stress of the KNN film was calculated from the amount of warpage of the substrate (Si substrate), that is, the radius of curvature of the warpage of the substrate, but the calculation is not limited thereto. As for the film stress of the KNN film, even in a state of a piezoelectric element (piezoelectric device module) in which a MEMS structure is formed by processing a piezoelectric stack, the film stress of the KNN can be known by comparing the MEMS simulation with the current shape.

(Evaluations on the Necessity of Polarization Processing)

Evaluations were conducted to confirm whether the KNN film in each of Samples 3 and 9 is a spontaneous polarization film, in other words, the necessity of polarization processing, the evaluations being conducted using a simple piezoelectric element fabricated from the piezoelectric stack of Sample 3 in which the median value of the coercive electric field is a positive value and a simple piezoelectric element fabricated from the piezoelectric stack of Sample 9 in which the median value of the coercive electric field is zero (0).

In a piezoelectric film such as a KNN film, piezoelectric deformation occurs when an electric field is applied in polarization directions, provided that the polarization directions are aligned in a uniform direction. Accordingly, it can be confirmed whether a KNN film is a spontaneous polarization film, in other words, the necessity of polarization processing, by applying a low voltage (electric field) to the KNN film on which polarization processing is not performed so as to confirm whether the KNN film is deformed.

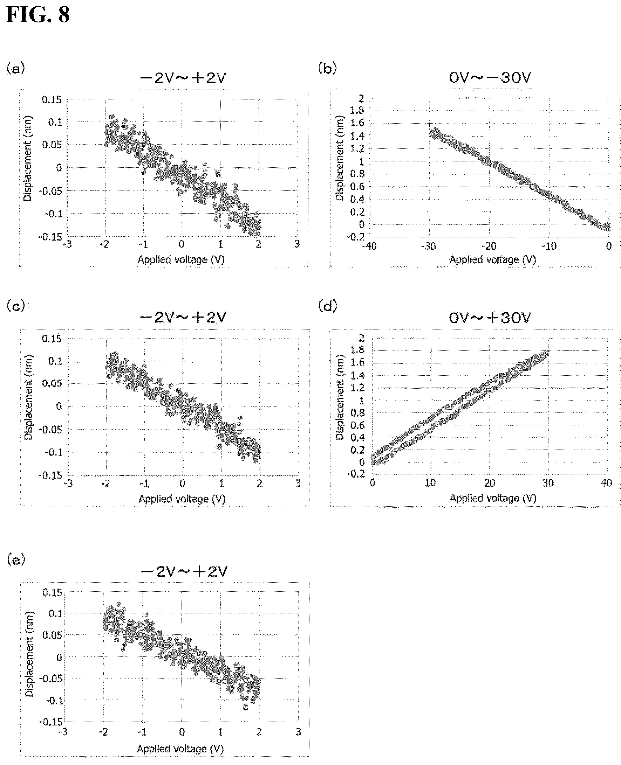

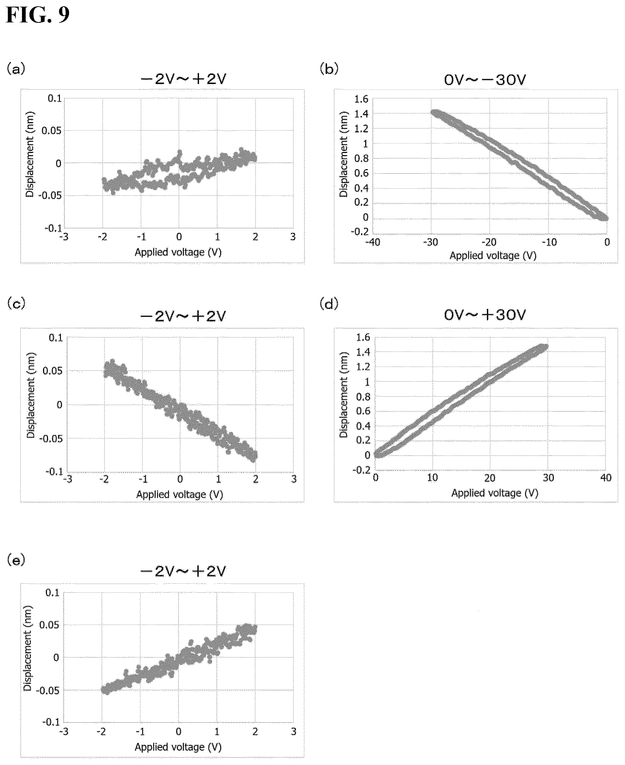

The confirmation of the necessity of the polarization processing is conducted by carrying out the following measurements (a) to (e) in this order. Graphs obtained from the measurements (a) to (e) are shown in FIGS. 8(a) to 8(e) and FIGS. 9(a) to 9(e). FIGS. 8(a) to 8(e) are graphs for Sample 3 and FIGS. 9(a) to 9(e) are graphs for Sample 9.

<Measurement (a)>

Firstly, using the simple piezoelectric element fabricated from each of Samples 3 and 9, a voltage of a sin wave of -2 V to +2 V (electric field of a sin wave of -10 kV/cm to +10 kV/cm) is applied to the KNN film through the top electrode film at a frequency of 1 kHz in a state in which the bottom electrode film is grounded, and a displacement amount of the KNN film (surface of the top electrode film) was measured (measurement (a)) to obtain a graph representing a correlation between the applied voltage and the displacement amount of the KNN film. FIG. 8(a) and FIG. 9(a) are graphs obtained in measurement (a).

<Measurement (b)>

After measurement (a), a voltage of a sin wave of 0 V to -30 V (electric field of a sin wave of 0 kV/cm to -300 kV/cm) is applied to the KNN film through the top electrode film at a frequency of 1 kHz in a state in which the bottom electrode film is grounded, and a displacement amount of the KNN film (surface of the top electrode film) was measured (measurement (b)) to obtain a graph representing a correlation between the applied voltage and the displacement amount of the KNN film. Applying the voltage of -30 V in the measurement (b) corresponds to conducting the processing of aligning the polarization in an upward direction (hereinafter, also referred to as "the polarization processing in the upward direction"). FIG. 8(b) and FIG. 9(b) are graphs obtained in measurement (b).

<Measurement (c)>

After measurement (b), again, a voltage of a sin wave of -2 V to +2 V (electric field of a sin wave of -10 kV/cm to +10 kV/cm) is applied to the KNN film through the top electrode film at a frequency of 1 kHz in a state in which the bottom electrode film is grounded, and a displacement amount of the KNN film (surface of the top electrode film) was measured (measurement (c)) to obtain a graph representing a correlation between the applied voltage and the displacement amount of the KNN film. FIG. 8(c) and FIG. 9(c) are graphs obtained in measurement (c).

<Measurement (d)>

After measurement (c), a voltage of a sin wave of 0 V to +30 V (electric field of a sin wave of 0 kV/cm to +300 kV/cm) is applied to the KNN film through the top electrode film at a frequency of 1 kHz in a state in which the bottom electrode film is grounded, and a displacement amount of the KNN film (surface of the top electrode film) was measured (measurement (d)) to obtain a graph representing a correlation between the applied voltage and the displacement amount of the KNN film. Applying the voltage of +30 V in the measurement (d) corresponds to conducting the processing of aligning the polarization in a downward direction (hereinafter, also referred to as "the polarization processing in the downward direction"). FIG. 8(d) and FIG. 9(d) are graphs obtained in measurement (d).

<Measurement (e)>

After measurement (d), again, a voltage of a sin wave of -2 V to +2 V (electric field of a sin wave of -10 kV/cm to +10 kV/cm) is applied to the KNN film through the top electrode film at a frequency of 1 kHz in a state in which the bottom electrode film is grounded, and a displacement amount of the KNN film (surface of the top electrode film) was measured (measurement (e)) to obtain a graph representing a correlation between the applied voltage and the displacement amount of the KNN film. FIG. 8(e) and FIG. 9(e) are graphs obtained in measurement (e).
For the simple piezoelectric element of Sample 3, piezoelectric displacement can be clearly confirmed in the graph in FIG. 8(a). It can also be confirmed that the piezoelectric displacement shown in the graph in FIG. 8(c) is similar to the piezoelectric displacement shown in the graph in FIG. 8(a). Accordingly, it is found that the polarization directions of the KNN film of Sample 3 are aligned in the upward direction from the initial state in which no polarization processing is performed. In other words, it is found that the KNN film of Sample 3 is a spontaneous polarization film. It can also be found that the piezoelectric displacement shown in the graph in FIG. 8(e) is similar to the piezoelectric displacement shown in the graphs in FIG. 8(a) and 8(c). Accordingly, it is found that the initial polarization state (polarization in the upward direction) is maintained even after conducting the processing corresponding to the polarization processing in the downward direction (measurement (d)) which is a opposite direction as in the processing corresponding to the polarization processing in the upward direction (measurement (b)). Accordingly, it is found that the spontaneous polarization generated in the KNN film of Sample 3 is maintained even after a large voltage is applied (regardless of forward or reverse direction). In other words, it is found in Sample 3 that no polarization processing is needed.
On the other hand, for the simple piezoelectric element of Sample 9, piezoelectric displacement cannot be clearly seen in the graph shown in FIG. 9(a), whereas piezoelectric displacement can be seen in the graph shown in FIG. 9(c). Accordingly, it is found in Sample 9 that the polarization directions of the KNN film were aligned in the upward direction (forward direction) by conducting the polarization processing in the upward direction (measurement (b)). In addition, piezoelectric displacement in a direction opposite to the piezoelectric displacement in FIG. 9(c) can be seen in FIG. 9(e). Accordingly, it is found that the polarization directions of the KNN film were changed to be aligned in the downward direction by conducting the polarization processing in the downward direction (measurement (d)) which is a opposite direction as in the polarization processing in the upward direction (measurement (b)). Therefore, it is found that spontaneous polarization is not generated in the KNN film of Sample 9, and the KNN film has a property that after applying a large voltage (regardless of the forward or reverse direction), polarization directions are aligned in a direction in which the large voltage is applied. Such a property of the KNN film of Sample 9 is a general property of KNN films (piezoelectric films) to which polarization processing is necessary. In other words, it is found in Sample 9 that polarization processing is needed.

(Evaluations on Temperature Withstand Capability of Spontaneous Polarization)

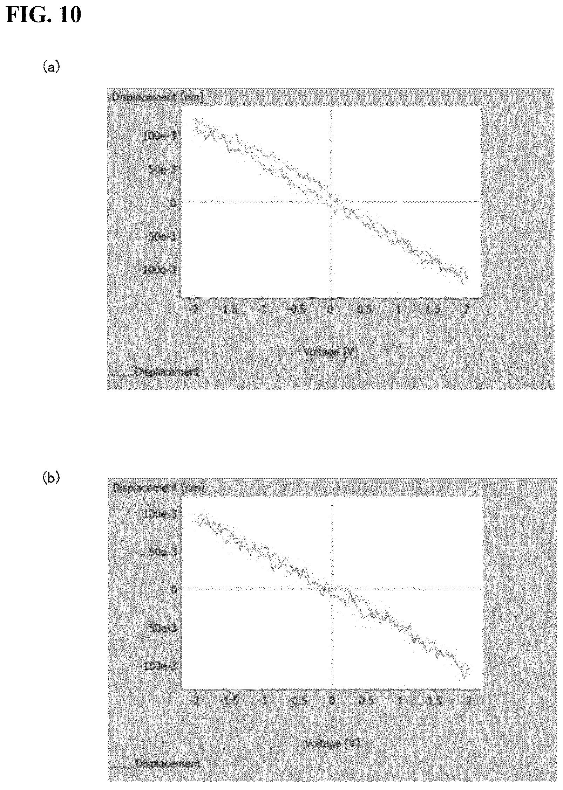

Using simple piezoelectric elements fabricated from the piezoelectric stacks of Samples 1 and 2, evaluations were conducted on temperature withstand capability of spontaneous polarization generated in KNN films.
Firstly, using the simple piezoelectric element fabricated from Sample 1, a voltage of a sin wave of -2 V to +2 V (electric field of a sin wave of -10 kV/cm to +10 kV/cm) is applied to the KNN film through the top electrode film at a frequency of 1 kHz in a state in which the bottom electrode film is grounded, and a displacement amount of the KNN film (surface of the top electrode film) was measured to obtain a graph representing a correlation between the applied voltage and the displacement amount of the KNN film. This graph is shown in FIG. 10(a). Then, the simple piezoelectric element was placed in an atmospheric environment at 400 °C for 2 hours. Then, again, a voltage of a sin wave of -2 V to +2 V (electric field of a sin wave of -10 kV/cm to +10 kV/cm) is applied to the KNN film through the top electrode film at a frequency of 1 kHz in a state in which the bottom electrode film is grounded, and a displacement amount of the KNN film (surface of the top electrode film) was measured to obtain a graph representing a correlation between the applied voltage and the displacement amount of the KNN film. This graph is shown in FIG. 10(b).

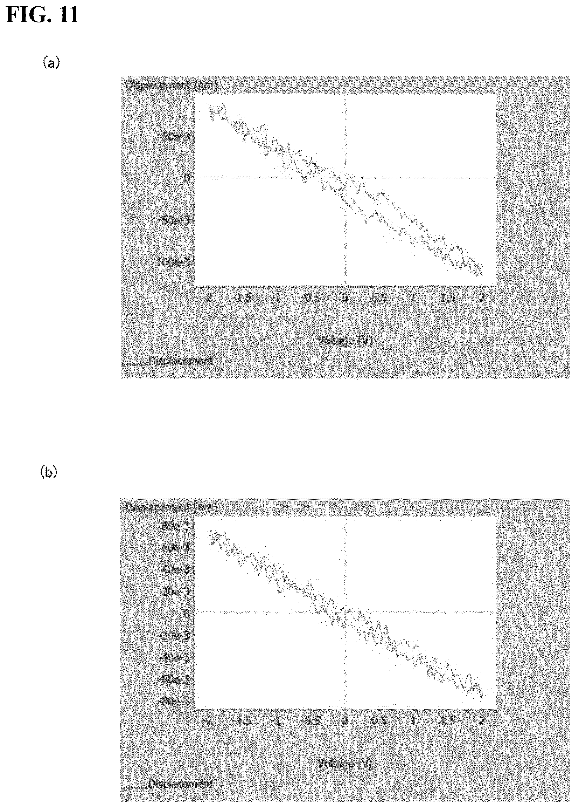

Using the simple piezoelectric element fabricated from Sample 2, a voltage of a sin wave of -2 V to +2 V (electric field of a sin wave of -10 kV/cm to +10 kV/cm) is applied to the KNN film through the top electrode film at a frequency of 1 kHz in a state in which the bottom electrode film is grounded, and a displacement amount of the KNN film (surface of the top electrode film) was measured to obtain a graph representing a correlation between the applied voltage and the displacement amount of the KNN film. This graph is shown in FIG. 11(a). Then, the simple piezoelectric element was placed in an atmospheric environment at 500 °C for 2 hours. Then, again, a voltage of a sin wave of -2 V to +2 V (electric field of a sin wave of -10 kV/cm to +10 kV/cm) is applied to the KNN film through the top electrode film at a frequency of 1 kHz in a state in which the bottom electrode film is grounded, and a displacement amount of the KNN film (surface of the top electrode film) was measured to obtain a graph representing a correlation between the applied voltage and the displacement amount of the KNN film. This graph is shown in FIG. 11(b).

It is found from FIGS. 10(a) and 10(b) that the piezoelectric displacement of the KNN film hardly changes before and after exposure to the atmosphere at 400 °C. In addition, it is found from FIGS. 11(a) and 11(b) that the piezoelectric displacement of the KNN film hardly changes before and after exposure to the atmosphere at 500 °C. Accordingly, it is found that the polarization property of the KNN film is maintained even when the KNN film undergoes a thermal history of 400 °C and further a thermal history of 500 °C, the KNN film being a spontaneous polarization film deposited by the method of the present disclosure.

Evaluations were conducted on temperature withstand capability of polarization generated in the KNN film of Sample 8 by conducting polarization processing on the KNN film of Sample 8. Specifically, firstly, a simple piezoelectric element fabricated from Sample 8 was prepared and polarization processing in the downward direction (that is, measurement (b)) was conducted. Then, a displacement amount of the KNN film was observed before and after exposure to atmosphere at 400 °C or 500 °C in a similar method as in Samples 1 and 2. Consequently, it has been confirmed in Sample 8 that piezoelectric displacement of the KNN film changed before and after the exposure to the atmosphere at 400 °C or 500 °C. Specifically, in Sample 8, while piezoelectric displacement was clearly confirmed before the exposure to the atmosphere at 400 °C or 500 °C, piezoelectric displacement was not clearly observed after the exposure to the atmosphere at 400 °C or 500 °C. That is, it has been confirmed that polarization is not generated in the KNN film of Sample 8 after the exposure to the atmosphere at 400 °C or 500 °C.

(Evaluation on Heat Resistance Performance of Piezoelectric Element)

Using simple piezoelectric elements (membrane MEMS devices) fabricated from the piezoelectric stacks of Samples 3 and 9, evaluations were conducted on heat resistance performance of piezoelectric elements.

Firstly, piezoelectric element chips were fabricated in the manner described below. The piezoelectric stacks of Samples 3 and 9 were prepared and an insulating film was provided from the top electrode film to the bottom electrode film so as to cover a part of a side surface of the KNN film of each of Samples 3 and 9. In the present experiment, a stack of an aluminum oxide ($Al_2O_3$) layer and a silicon oxide ($SiO_2$) layer provided on the $Al_2O_3$ layer was provided as the insulating film, the $Al_2O_3$ layer having a thickness of 5 nm and the $SiO_2$ layer having a thickness of 500 nm. Next, the insulating film was patterned by dry etching using $CF_4$ gas. Then, a stack of a Ti layer and an Au layer provided on the Ti layer was provided as a metal wiring layer, the Ti layer having a thickness of 10 nm and the Au layer having a thickness of 300 nm. After that, metal wiring of a predetermined pattern was formed by patterning the metal wiring layer by wet etching. In addition, a membrane structure was formed by removing a part of the Si substrate from a back surface of the Si substrate by Deep-RIE. Finally, a plurality of such piezoelectric element chips as illustrated in FIG. 3 were fabricated by dividing the piezoelectric stacks (Samples 3 and 9) into chips.

Then, polarization processing of applying a DC voltage of -30 V to the KNN film through the top electrode film by probing was performed on the piezoelectric element chip fabricated using the piezoelectric stack of Sample 9 in which spontaneous polarization was not generated. The polarization processing was not performed on the piezoelectric element chip fabricated using the piezoelectric stack of Sample 3 in which spontaneous polarization was generated.

Then, the plurality of resulting piezoelectric element chips were implemented (by bonding and wire bonding) on a package. In order to evaluate heat resistance performance of the fabricated piezoelectric element chips, the heating processing was conducted at a temperature (hereinafter, also referred to as "PKG temperature") of 200 °C and 300 °C at the time of implementing the piezoelectric element chips on the package.

In this piezoelectric element (membrane MEMS device), a portion of the membrane structure is deformed by sound pressure of ultrasonic waves, and a voltage is generated from the KNN film. That is, this piezoelectric element functions as an ultrasonic sensor. Ultrasonic waves were applied to each of the fabricated piezoelectric element chips, and the sensitivity of the piezoelectric element to ultrasonic waves (that is, sensor sensitivity, hereinafter also referred to as "ultrasonic sensitivity") was evaluated. The evaluation results are shown in Table 3 below. In the column of "Ultrasonic sensitivity" in Table 3, "Pass" means that the piezoelectric element after being implemented on the package was normally operated, and "Fail" means that the piezoelectric element after being implemented on the package was not normally operated.

[Table 3]

|  | Polarization Processing | PKG temperature | Ultrasonic sensitivity |
|---|---|---|---|
| Sample 3 | No | 200 °C | Pass |
| Sample 3 | No | 300 °C | Pass |
| Sample 9 | Yes | 200 °C | Pass |
| Sample 9 | Yes | 300 °C | Fail |

The piezoelectric element fabricated using the piezoelectric stack of Sample 3 operated normally regardless of the PKG temperature.

On the other hand, the piezoelectric element fabricated using the piezoelectric stack of Sample 9 and subjected to polarization processing normally operated when the PKG temperature was 200 °C, but did not normally operate when the PKG temperature was 300 °C. Accordingly, it is found that the ultrasonic sensitivity is degraded in the piezoelectric element which undergoes the thermal history of 300 °C after the polarization processing. This is presumably because polarization directions of the KNN film aligned by the polarization processing were disturbed by the exposure to a high temperature. Therefore, it is found that the piezoelectric element fabricated using the spontaneous polarization KNN film exhibits higher heat resistance performance as compared with the piezoelectric element subjected to the polarization processing. It is found that the piezoelectric element fabricated using the spontaneous polarization KNN film exhibits high heat resistance performance and high reliability.

<Preferred Modes of the Present Disclosure>

Hereinafter, preferred modes of the present disclosure will be additionally described.

(Supplementary description 1)

According to one aspect of the present disclosure, there is provided a piezoelectric stack including:

a substrate;
a bottom electrode film deposited on the substrate; and
a piezoelectric film deposited on the bottom electrode film, the piezoelectric film being constituted by an alkali niobium oxide containing potassium, sodium, niobium and oxygen, wherein
in a hysteresis curve representing a correlation between a polarization amount and an applied electric field, a median value of a coercive electric field between a coercive electric field $E_C^+$ on a positive electric field side and a coercive electric field $E_C^-$ on a negative electric field side is a positive value, the hysteresis curve being obtained by applying an electric field to the piezoelectric film under a predetermined condition,
a relative dielectric constant of the piezoelectric film is 490 or less, and
a film stress of the piezoelectric film is 150 MPa or less.

(Supplementary description 2)

The piezoelectric stack according to the supplementary description 1, wherein preferably,
when a thickness of the piezoelectric film is 2 $\mu$m, the median value of the coercive electric field between the coercive electric field $E_C^+$ and the coercive electric field $E_C^-$ in the hysteresis curve is 10 kV/cm or more.

(Supplementary description 3)

The piezoelectric stack according to the supplementary description 1 or 2, wherein preferably,
when a negative voltage is continuously applied to a top electrode film provided on the piezoelectric film in such a manner that a unipolar alternating electric field of 300 kV/cm is generated between the bottom electrode film and the top electrode film, the number of application cycles of the negative voltage until a piezoelectric displacement amount of the piezoelectric film decreases to 80 % or less of an initial piezoelectric displacement value is more than 10 million.

(Supplementary description 4)

The piezoelectric stack according to any one of the supplementary descriptions 1 to 3, wherein preferably, the piezoelectric film contains, as a dopant, at least one element selected from copper and manganese at a concentration of 0.1 atomic percent or more and 2.0 atomic percent or less.

(Supplementary description 5)

The piezoelectric stack according to any one of the supplementary descriptions 1 to 4, wherein preferably, a layer containing zinc and oxygen is provided between the substrate and the piezoelectric film.

(Supplementary description 6)

According to another aspect of the present disclosure, there is provided a method for manufacturing a piezoelectric stack, the method including:

depositing a bottom electrode film on a substrate; and
depositing a piezoelectric film on the bottom electrode film, the piezoelectric film being constituted by an alkali niobium oxide containing potassium, sodium, niobium, and oxygen, wherein
the depositing of the piezoelectric film involves firstly depositing a first piezoelectric film as a part of the piezoelectric film at a first temperature at which a (001) orientation ratio becomes 95 % or more and a film stress becomes 100 MPa or less, and then depositing a second piezoelectric film as another part of the piezoelectric film on the first piezoelectric film at a second temperature at which the second piezoelectric film becomes a spontaneous polarization film.

(Supplementary description 7)

The method according to the supplementary description 6, wherein preferably, a thickness of the first piezoelectric film is 20 % or less of total thickness of the piezoelectric film.

(Supplementary description 8)

The method according to the supplementary description 6 or 7, wherein preferably, the first temperature is a temperature at which the (001) orientation ratio of the first piezoelectric film becomes 95 % or more when the first piezoelectric film having a thickness of 2 $\mu$m is deposited at the first temperature.

(Supplementary description 9)

The method according to any one of the supplementary descriptions 6 to 8, wherein preferably, the first temperature is a temperature at which a film stress of the first piezoelectric film becomes 100 MPa or less when the first piezoelectric film having a thickness of 2 $\mu$m is deposited at the first temperature.

(Supplementary description 10)

The method according to any one of the supplementary descriptions 6 to 9, wherein preferably,

the method further includes providing a layer containing zinc and oxygen on the substrate before the depositing of the piezoelectric film, and
in the depositing of the piezoelectric film, the piezoelectric film is deposited on the layer containing zinc and oxygen.

(Supplementary description 11)

According to yet another aspect of the present disclosure, there is provided a piezoelectric element or a piezoelectric device module, including:

a substrate;
a bottom electrode film deposited on the substrate;
a piezoelectric film deposited on the bottom electrode film, the piezoelectric film being constituted by an alkali niobium oxide containing potassium, sodium, niobium and oxygen; and
a top electrode film deposited on the piezoelectric film, wherein
in a hysteresis curve representing a correlation between a polarization amount and an applied electric field, a median value of a coercive electric field between a coercive electric field $E_C^+$ on a positive electric field side and a coercive electric field $E_C^-$ on a negative electric field side is a positive value, the hysteresis curve being obtained by applying an electric field to the piezoelectric film under a predetermined condition,
a relative dielectric constant of the piezoelectric film is 490 or less, and
a film stress of the piezoelectric film is 150 MPa or less.

(Supplementary description 12)

According to yet another aspect of the present disclosure, there is provided a piezoelectric element or a piezoelectric device module utilizing a polarization property of a piezoelectric film, wherein

there is implemented a piezoelectric film in which, in a hysteresis curve representing a correlation between a polarization amount and an applied electric field, a median value of a coercive electric field between a coercive electric field $E_C^+$ on a positive electric field side and a coercive electric field $E_C^-$ on a negative electric field side is a positive value, the hysteresis curve being obtained by applying an electric field to the piezoelectric film under a predetermined condition, and
sensor sensitivity of the piezoelectric element or the piezoelectric device module is not degraded (sensor sensitivity is maintained) even when the piezoelectric element or the piezoelectric device module undergoes a thermal history of 300 °C.

(Supplementary description 13)

According to yet another aspect of the present disclosure, there is provided a piezoelectric film constituted by an alkali niobium oxide containing potassium, sodium, niobium and oxygen, wherein

in a hysteresis curve representing a correlation between a polarization amount and an applied electric field, a median value of a coercive electric field between a coercive electric field $E_C^+$ on a positive electric field side and a coercive electric field $E_C^-$ on a negative electric field side is a positive value, the hysteresis curve being obtained by applying an electric field to the piezoelectric film under a predetermined condition,
a relative dielectric constant of the piezoelectric film is 490 or less, and
a film stress of the piezoelectric film is 150 MPa or less.

(Supplementary description 14)

According to yet another aspect of the present disclosure, there is provided a piezoelectric film, wherein

in a hysteresis curve representing a correlation between a polarization amount and an applied electric field, a median value of a coercive electric field between a coercive electric field $E_C^+$ on a positive electric field side and a coercive electric field $E_C^-$ on a negative electric field side is a positive value, the hysteresis curve being obtained by applying an electric field to the piezoelectric film under a predetermined condition, and
polarization property is maintained even when piezoelectric film undergoes a thermal history of 400 °C or more.

(Supplementary description 15)

The piezoelectric film, the piezoelectric element, or the piezoelectric device module according to any one of the supplementary descriptions 11 to 14, wherein preferably,
when a negative voltage is continuously applied to a top electrode film (provided on the piezoelectric film) in such a manner that a unipolar alternating electric field of 300 kV/cm is generated between the bottom electrode film and the top electrode film (in the piezoelectric film), the number of application cycles of the negative voltage until a piezoelectric displacement amount of the piezoelectric film decreases to 80 % or less of an initial piezoelectric displacement value is more than 10 million.

[Reference Signs List]

| | |
|---|---|
| 1 | Substrate |
| 2 | Bottom electrode film |
| 3 | Piezoelectric film |
| 4 | Top electrode film |
| 6 | Bottom adhesion layer |
| 10 | Piezoelectric stack |
| 20 | Piezoelectric element |
| 30 | Piezoelectric device module |

**Claims**

1. A piezoelectric stack comprising:

   a substrate;
   a bottom electrode film deposited on the substrate; and
   a piezoelectric film deposited on the bottom electrode film, the piezoelectric film being constituted by an alkali niobium oxide containing potassium, sodium, niobium and oxygen, wherein
   in a hysteresis curve representing a correlation between a polarization amount and an applied electric field, a median value of a coercive electric field between a coercive electric field $E_C^+$ on a positive electric field side and a coercive electric field $E_C^-$ on a negative electric field side is a positive value, the hysteresis curve being obtained by applying an electric field to the piezoelectric film under a predetermined condition,
   a relative dielectric constant of the piezoelectric film is 490 or less, and
   a film stress of the piezoelectric film is 150 MPa or less.

2. The piezoelectric stack according to claim 1, wherein when an alternating negative voltage is continuously applied to a top electrode film provided on the piezoelectric film in such a manner that a unipolar alternating electric field of 300 kV/cm is generated between the bottom electrode film and the top electrode film, the number of application cycles of the alternating negative voltage until a piezoelectric displacement amount of the piezoelectric film decreases to 80 % or less of an initial piezoelectric displacement value is more than 10 million.

3. The piezoelectric stack according to claim 1 or 2, wherein the piezoelectric film contains, as a dopant, at least one element selected from copper and manganese at a concentration of 0.1 atomic percent or more and 2.0 atomic percent or less.

4. A method for manufacturing a piezoelectric stack, the method comprising:

   depositing a bottom electrode film on a substrate; and
   depositing a piezoelectric film on the bottom electrode film, the piezoelectric film being constituted by an alkali niobium oxide containing potassium, sodium, niobium, and oxygen, wherein
   the depositing of the piezoelectric film involves firstly depositing a first piezoelectric film as a part of the piezoelectric film at a first temperature at which a (001) orientation ratio becomes 95 % or more and a film stress becomes 100 MPa or less, and then depositing a second piezoelectric film as another part of the piezoelectric film on the first piezoelectric film at a second temperature at which the second piezoelectric film becomes a spontaneous polarization film.

5. A piezoelectric element comprising:

   a substrate;
   a bottom electrode film deposited on the substrate;
   a piezoelectric film deposited on the bottom electrode film, the piezoelectric film being constituted by an alkali niobium oxide containing potassium, sodium, niobium and oxygen; and
   a top electrode film deposited on the piezoelectric film, wherein
   in a hysteresis curve representing a correlation between a polarization amount and an applied electric field, a median value of a coercive electric field between a coercive electric field $E_C^+$ on a positive electric field side and a coercive electric field $E_C^-$ on a negative electric field side is a positive value, the hysteresis curve being obtained by applying an electric field to the piezoelectric film under a predetermined condition,
a relative dielectric constant of the piezoelectric film is 490 or less, and
a film stress of the piezoelectric film is 150 MPa or less.

6. The piezoelectric element according to claim 5, wherein when an alternating negative voltage is continuously applied to the top electrode film in such a manner that a unipolar electric field of 300 kV/cm is generated between the bottom electrode film and the top electrode film, the number of application cycles of the alternating negative voltage until a piezoelectric displacement amount of the piezoelectric film decreases to 80 % or less of an initial piezoelectric displacement value is more than 10 million.

**FIG. 1**

**FIG. 2**

**FIG. 3**

20

**FIG. 4**

30

FIG. 5

FIG. 6

# FIG. 7

(a)

(b)

# FIG. 8

(a)

(b)

(c)

(d)

(e)

# FIG. 9

(a)

(b)

(c)

(d)

(e)

**FIG. 10**

(a)

(b)

# FIG. 11

(a)

(b)

# EP 4 694 656 A1

## INTERNATIONAL SEARCH REPORT

International application No.

**PCT/JP2023/045473**

**A. CLASSIFICATION OF SUBJECT MATTER**

*H10N 30/853*(2023.01)i; *H10N 30/01*(2023.01)i; *H10N 30/30*(2023.01)i; *H10N 30/076*(2023.01)i; *H10N 30/079*(2023.01)i; *H10N 30/87*(2023.01)i; *H10N 30/093*(2023.01)i

FI: H10N30/853; H10N30/076; H10N30/30; H10N30/87; H10N30/01; H10N30/079; H10N30/093

According to International Patent Classification (IPC) or to both national classification and IPC

**B. FIELDS SEARCHED**

Minimum documentation searched (classification system followed by classification symbols)

H10N30/853; H10N30/01; H10N30/30; H10N30/076; H10N30/079; H10N30/87; H10N30/093

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2014-207429 A (HITACHI METALS LTD.) 30 October 2014 (2014-10-30) paragraphs [0013], [0020], [0023], [0026], [0042], fig. 1, 7 | 1, 3, 5 |
| A | | 2, 4, 6 |
| Y | JP 2015-529963 A (TDK CORPORATION) 08 October 2015 (2015-10-08) paragraphs [0006], [0012], [0024], [0031], [0036], fig. 1, 3-4 | 1, 3, 5 |
| A | | 2, 4, 6 |
| Y | JP 2017-76730 A (SCIOCS CO., LTD., SUMITOMO CHEMICAL CO., LTD.) 20 April 2017 (2017-04-20) paragraphs [0006], [0015], [0018], [0021], [0036], fig. 1 | 3 |
| A | | 1-2, 4-6 |

☐ Further documents are listed in the continuation of Box C. ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **20 February 2024** | **05 March 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2023/045473**

| Patent document cited in search report | | | Publication date (day/month/year) | Patent family member(s) | | | Publication date (day/month/year) |
|---|---|---|---|---|---|---|---|
| JP | 2014-207429 | A | 30 October 2014 | US | 2014/0285068 | A1 | |
| | | | | paragraphs [0014], [0039], [0042], [0045], [0064], fig. 1, 7 | | | |
| | | | | CN | 104064670 | A | |
| JP | 2015-529963 | A | 08 October 2015 | US | 8994251 | B2 | |
| | | | | column 1, line 60 to column 2, line 4, column 2, lines 53-57, column 4, lines 18-26, column 5, lines 41-51, column 6, lines 19-29, fig. 1, 3-4 | | | |
| | | | | WO | 2014/021410 | A1 | |
| | | | | CN | 104395087 | A | |
| JP | 2017-76730 | A | 20 April 2017 | US | 2018/0301618 | A1 | |
| | | | | paragraphs [0007], [0043], [0046], [0049], [0064], fig. 1 | | | |
| | | | | US | 2021/0359195 | A1 | |
| | | | | WO | 2017/065133 | A1 | |
| | | | | EP | 3364471 | A1 | |
| | | | | EP | 3922749 | A1 | |

Form PCT/ISA/210 (patent family annex) (July 2022)

**EP 4 694 656 A1**

**Patent documents cited in the description**

- JP 2014207429 A
- JP 2011029591 A